(19) Europäisches Patentamt
European Patent Office
Office européen des brevets

(11) EP 1 612 249 A1

(12) EUROPEAN PATENT APPLICATION

(43) Date of publication:
**04.01.2006 Bulletin 2006/01**

(51) Int Cl.:
***C09G 1/02*** *(2006.01)* ***C09G 1/04*** *(2006.01)*
***H01L 21/321*** *(2006.01)*

(21) Application number: **05014388.2**

(22) Date of filing: **01.07.2005**

(84) Designated Contracting States:
**AT BE BG CH CY CZ DE DK EE ES FI FR GB GR HU IE IS IT LI LT LU LV MC NL PL PT RO SE SI SK TR**
Designated Extension States:
**AL BA HR MK YU**

(30) Priority: **01.07.2004 JP 2004195730**
**27.09.2004 JP 2004279491**
**27.09.2004 JP 2004279703**

(71) Applicant: **FUJI PHOTO FILM CO., LTD.**
**Minami-Ashigara-shi, Kanagawa (JP)**

(72) Inventors:
- **Seki, Hiroyuki**
**Yoshida-cho**
**Haibara-gun**
**Shizuoka (JP)**
- **Asanuma, Naoki**
**Minami-Ashigara-shi**
**Kanagawa (JP)**
- **Ishikawa, Takatoshi**
**Yoshida-cho**
**Haibara-gun**
**Shizuoka (JP)**
- **Yamashita, Katsuhiro**
**Yoshida-cho**
**Haibara-gun**
**Shizuoka (JP)**
- **Akatsuka, Tomohiko**
**Yoshida-cho**
**Haibara-gun**
**Shizuoka (JP)**

(74) Representative: **HOFFMANN EITLE**
**Patent- und Rechtsanwälte**
**Arabellastrasse 4**
**81925 München (DE)**

# (54) Polishing solution of metal and chemical mechanical polishing method

(57) A polishing solution for metal comprises a specific compound represented and an oxidizing agent. A chemical mechanical polishing method for a semiconductor substrate, comprises: supplying a polishing solution for metal comprising a specific compound; and an oxidizing agent; allowing a polishing face and a face to be polished to be moved relatively to each other while the polishing face and the face to be polished are in contact with each other via the polishing solution for metal; and performing polishing with a contact pressure between the polishing face and the face to be polished in the range of from 1000 to 25000 Pa.

EP 1 612 249 A1

## Description

## Background of the Invention

### 1. Field of the Invention

The present invention relates to production of a semiconductor device and, particularly, to a polishing solution for metal in a wiring step of the semiconductor device and a polishing method using the polishing solution for metal.

### 2. Description of the Related Art

In a development of the semiconductor device represented by a semiconductor integrated circuit (hereinafter referred to also as "LSI"), due to a trend of higher integration and a higher speed, in recent years, a higher density and a higher integration by means of fineness and laminates are required. For realizing such technique .as described above, chemical mechanical polishing (hereinafter, referred to also as "CMP") has been used and this polishing is a method in which it is used for polishing an insulating thin film ($SiO_2$ or the like) to flatten a substrate or remove an excess metallic thin film at the time of forming the wiring and is described in, for example, USP No. 4944836.

The polishing solution for metal to be used in the CMP ordinarily contains abrasive grains (for example, alumina) and an oxidizing agent (for example, hydrogen peroxide). A basic mechanism is considered to be that a surface of metal is first oxidized by the oxidizing agent and, then, the resultant oxidized film is removed by the abrasive grains and is described in, for example, Journal of Electrochemical Society, Vol. 138, No. 11, pp. 3460 to 3464 (1991).

However, when the CMP is performed by using the abrasive solution for metal containing such solid abrasive grains as described above, a polishing scar (scratch), a phenomenon in which an entire polished face is polished to an unnecessary extent (thinning), a phenomenon in which a polished metal face is depressed like a dish (dishing), a phenomenon in which not only an insulator between metallic wirings is polished to an unnecessary extent but also a wiring metal face is depressed like a dish (erosion) and the like may sometimes be generated. As a measure to suppress such detrimental effect as described above, it is described effective in, for example, JP-A Nos. 8-64594 and 8-83780 to allow 1,2,3-benzotriazole or 2-aminothiazole to be contained in the polishing solution.

However, when such corrosion suppressing agent is used, a time period required for polishing becomes long, to thereby invite a disadvantage such that productivity is decreased. Further, when the polishing solution containing solid abrasive grains is used, a washing process thereof becomes complicated and, in order to treat a liquid (waste liquid) after the washing process, it is necessary to precipitate the solid abrasive grains and, accordingly, there is a problem of cost.

Further, in a washing step which is ordinarily performed for removing the polishing solution remaining on a semiconductor face after polishing, by using the polishing solution containing the solid abrasive grains, not only the washing step comes to be complicated, it is necessary to precipitate and separate the solid abrasive grains in order to treat a solution (waste liquid) after washing and, accordingly, there are problems in cost and the like.

As a measure to solve these problems, for example, a metal surface polishing method in which a combination of the polishing solution without containing the abrasive grains and dry etching is utilized is described in Journal of Electrochemical Society, Vol. 147, No. 10, pp. 3907 to 3913 (2000), as a specific example thereof, a polishing solution for metal containing hydrogen peroxide, malic acid, benzotriazole, ammonium polyacrylate and water is proposed in, for example, JP-A No. 2001-127019. According to these methods, a metallic film on a convex portion of the semiconductor substrate is selectively subjected to the CMP and the metallic film in a concave portion is left, to thereby obtain a flat semiconductor pattern. In this method, since the CMP is progressed by a friction with a polishing pad which is mechanically by far softer than a conventional polishing pad containing solid abrasive grains, generation of scratches is reduced. However, the problem has not been solved such that a long polishing time period is required and it is difficult to simultaneously satisfy planarity and flatness of a polished face and a polishing rate.

On the other hand, an impressed pressure which is provided on the face to be polished by the polishing pad is ordinarily 20000 Pa or more. Although it is considered that, when the impressed pressure is reduced, an excessive or uneven corrosion of the face to be polished is suppressed and, then, the planarity and the flatness can be improved, it is difficult to simultaneously satisfy such improvements as described above and the polishing rate. Then, a method for reducing the impressed pressure by adding an accelerating agent for dissolving the polishing face in the polishing solution is proposed. Namely, in JP-A No. 2003-289055, a method in which a polishing solution containing a polycarboxyheterocyclic compound is used and, then, the chemical mechanical polishing is performed under an impressed pressure of 700 to 18000 Pa is described and, also, in JP-A No. 2004-6628, a method in which a polishing solution simultaneously containing a benzotriazole-based compound, and imidazole or benzoimidazole is used and, then, the chemical mechanical polishing is performed under an impressed pressure of 10000 Pa or less is described.

On the other hand, as metals for wiring, tungsten and aluminum have conventionally been generally used in

an interconnection structure. However, aiming for a higher performance, an LSI using copper which is lower in wiring resistance than these metals has been developed. As for a method for forming wirings by using copper, a damascene method as described in, for example, JP-A No. 2-278822 has been known. Further, a dual-damascene method in which a contact hole and a trench for witing are simultaneously formed on an interlayer insulating film and, then, a metal is buried in both of the hole and the trench has come to be widely used. For a target material for such copper wiring as described above, a high-purity copper target of five nines or more has been shipped. However, in recent years, along with a trend of higher fineness of wiring aiming for a higher density, it has become necessary to enhance electric conductivity or electronic properties of the copper wiring. Accordingly, along with such necessity, application of a copper alloy in which a third component is added to the high-purity copper has come to be studied. At the same time, a high-speed metal polishing measure capable of exhibiting a high productivity without contaminating these precise highly-pure materials is required.

Further, in recent years, in order to enhance productivity, a diameter of a wafer has been enlarged at the time of producing the LSI and, at present day, the diameter of 200 mm or more is prevailing and production thereof with the diameter of 300 mm or more has come to be produced. Along with such trend of enlargement of the diameter of the wafer as described above, a difference in polishing rate between a central portion and a peripheral portion of the wafer has become large and, then, a request for improvement of a wafer in-plane uniformity has become strong.

As for a chemical polishing method having no mechanical polishing measure against copper or a copper alloy, a method as described in JP-A No. 49-122432 is known. However, in the chemical polishing method depending only on a dissolving action, there leaves a problem in flatness thereof due to generation of dishing or the like, compared with the CMP in which the metal film in the convex portion is selectively polished in a chemical mechanical manner.

Further, although an aqueous dispersion for chemical mechanical polishing which suppresses deterioration of a polishing pad is described in JP-A No. 2001-279231, the dispersion relates to flattening of an uneven section of a polishing surface.

## Summary of the Invention

Being based on the background that, in performing a faster CMP for enhancing productivity of an LSI, an enhancement of a polishing rate of wiring having copper or a copper alloy as a material has been required, the present invention has been achieved.

Therefore, an object of the present invention is to provide a polishing solution for metal having a high CMP speed, securing a wafer in-plane uniformity and capable of producing an LSI less generating dishing or the like.

The present inventor has exerted an intensive study on problems concerning the above-described polishing solution for metal and, as a result, has found that these problems can be solved by using a polishing solution for metal as described below and attained the object. Namely, the first invention relates to as follows:

(1) a polishing solution for metal, being characterized by containing a compound represented by the following general formula (I) and an oxidizing agent:

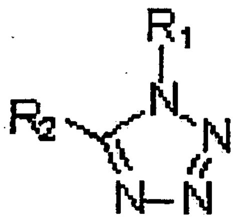

(I)

wherein $R_1$ and $R_2$ each independently represents a hydrogen atom or a substituent, $R_1$ and $R_2$ may form a ring by combining with each other and, when $R_1$ and $R_2$ simultaneously represent a hydrogen atom, the compound represented by formula (I) may be a tautomer;

(2) the polishing solution as described in the above-described (1), which either not comprises abrasive grains or comprises the abrasive grains in a concentration of less than 0.01% by mass;

(3) the polishing solution for metal as described in the above-described (1), which comprises the abrasive grains in a concentration of 0.01% by mass or more;

(4) the polishing solution for metal as described in any one of the above-described (1) to (3), further comprising at least one of an organic acid and an amino acid; and

(5) a chemical mechanical polishing method, comprising: allowing the polishing solution for metal as described in any one of the above-described (1) to (4) to be in contact with a surface to be polished; and performing polishing

by moving the surface to be polished and a polishing surface relatively to each other.

In recent years, as fineness of a semiconductor substrate has progressed and length of wiring has become longer, wiring delay (RC delay) appears to be a problem. Since the RC delay is proportional to resistivity of the wiring and specific inductive capacity of an inter-wiring insulating film, a realization of a low dielectric constant of the inter-wiring insulating film is in progress. However, many raw materials of the insulating film having a low dielectric constant are brittle and have a low mechanical strength, to thereby cause a problem such as peeling of the insulating film in a polishing process of the semiconductor substrate containing such raw material as described above. Since a main cause of this peeling is a frictional force between a polishing face and a face to be polished, reduction of the frictional force by reducing a contact pressure has been studied. However, it is known that a machining amount is proportional to a product of a relative movement speed, a contact pressure and a time period and, then, as a processing condition of the semiconductor substrate containing the insulating film having a low dielectric constant, a polishing agent capable of obtaining a high polishing rate even under a low contact pressure and excellent in a dishing performance is required.

Therefore, an object of the present invention is to provide a chemical mechanical polishing method which can appropriately suppress an etching rate and, also, efficiently suppress dishing without excessively sacrificing a chemical mechanical polishing rate.

The present inventor has exerted an intensive study on problems concerning the above-described polishing solution for metal and, as a result, has found that an impressed pressure to a face to be polished can be reduced while maintaining a polishing rate by using a polishing solution for metal containing a heterocyclic compound having a specified structure and the problems have been solved. Namely, the second invention relates to as follows:

(6) a chemical mechanical polishing method for a semiconductor substrate, comprising: supplying a polishing solution for metal comprising at least one compound selected from among compounds represented by the following general formulae (I) and (II) and an oxidizing agent; allowing a polishing face and a face to be polished to be moved relatively to each other while the polishing face and the face to be polished are in contact with each other via the polishing solution for metal; and performing polishing with a contact pressure between the polishing face and the face to be polished in the range of from 1000 to 25000 Pa:

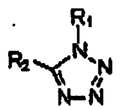 (I)

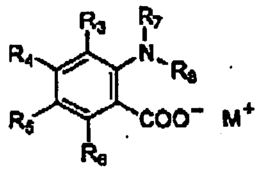 (II)

wherein $R_1$ and $R_2$ each independently represents a hydrogen atom or a substituent, $R_1$ and $R_2$ may form a ring by combining with each other and, when $R_1$ and $R_2$ simultaneously represent a hydrogen atom, the compound represented by formula (I) may be a tautomer; and $R_3$ to $R_8$ each independently represents a hydrogen atom or a substituent, any two adjacent to each other of $R_3$ to $R_8$ may form a ring by combining with each other and $M^+$ represents a cation;

(7) the chemical mechanical polishing method for the semiconductor substrate as described in the above-described (6), wherein a speed of an average relative movement between the polishing face and the face to be polished is in the range of 0.5 to 5.0 m/s; and

(8) the chemical mechanical polishing method for the semiconductor substrate as described in the above-described (6) or (7), wherein the face to be polished is a face comprising at least one of copper, a copper alloy, a tantalum-containing compound and an insulating material having a low dielectric constant.

The invention is characterized in that the compound represented by the general formula (I) or (II) is allowed to be contained in the polishing solution for metal and the impressed pressure to the face to be polished is allowed to be 1000 to 25000 Pa. The compound represented by the general formula (I) or (II) is characterized by having a uniform corrosion property and less having a polishing suppressing property. As a result, it has been found that, even under a low impressed pressure, a necessary polishing rate can be maintained and the invention has been achieved.

## Brief Description of the Drawings

FIG. 1 is a plan view of rotary polishing face containing a polishing face and a face to be polished for explaining an average relative speed; and

FIG. 2 is a diagram showing a relation between a concentration of an etching suppressing agent and an etching rate in Example 2-2.

## Detailed Description of the Invention

Hereinafter, the present invention is described with reference to specific embodiments.

The term "group (atomic group)" as used herein without any reference to substitution and non-substitution is intended to include a group having a substituent and a group not having a substituent. For example, the term "alkyl group" is intended to include not only the alkyl group having no substituent (non-substituted alkyl group) but also the alkyl group having a substituent (substituted alkyl group).

A polishing solution for metal according to the first invention contains at least a compound represented by the general formula (I) and an oxidizing agent as constituents, ordinarily is an aqueous solution and preferably contains at least one compound selected from organic acids and amino acids.

The polishing solution for metal according to the second invention contains at least one of compounds represented by the general formulae (I) and (II) and an oxidizing agent as constituents, ordinarily is an aqueous solution and preferably contains at least one acid selected from organic acids and amino acids.

The polishing solution for metal according to the invention may further contain other components than those described above and examples of preferable components include a surfactant, a water-soluble polymer and an additive.

These components which the polishing solution for metal contains may be used either in one type or in combination of two or more types.

Further, an amount of a component to be compounded having a solubility of less than 5% against water at room temperature among components to be added at the time of preparation of a concentrated solution of the polishing solution for metal is preferable that showing less than two times the solubility against water at room temperature and, more preferably less than 1.5 time.

Still further, "concentration" and "concentrated solution" as used herein means those used in accordance with idiomatic expressions of "thickness" and "thickened solution", respectively, differently from ordinary expressions implying physical concentration operations such as evaporation and the like.

Namely, the concentrated solution or concentrated polishing solution means the polishing solution which has been prepared so as to have a higher concentration than that at the time of being used in polishing and, accordingly, when it is used for polishing, it is diluted with water, a solution or the like and, then, used. A dilution ratio thereof is ordinarily 1 to 20 times the original volume.

The term "polishing solution for metal" as used herein is intended to include not only the polishing solution to be actually used for polishing (namely, the polishing solution which has been diluted as required) but also a concentrated solution thereof.

Hereinafter, each component will be described.

[Compound represented by the general formula (I)]

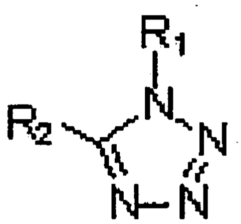

(I)

wherein $R_1$ and $R_2$ each independently represents a hydrogen atom or a substituent wherein $R_1$ and $R_2$ may form a ring by combining with each other and, further, when $R_1$ and $R_2$ simultaneously represent a hydrogen atom, the compound represented by the general formula (I) may be a tautomer.

Substituents represented by $R_1$ and $R_2$ in the general formula (I) are not particularly limited and examples thereof include: a halogen atom (a fluorine atom, a chlorine atone, a bromine atom or an iodine atom), an alkyl group (a linear, branched or cyclic alkyl group, a polycyclic alkyl group such as a bicycloalkyl group or an alkyl group containing an active methine group), an alkenyl group, an alkynyl group, an aryl group, a heterocyclic group (regardless of a position

to be substituted), an acyl group, an alkoxycarbonyl group, an aryloxycarbonyl group, a heterocyclic oxycarbonyl group, a, carbamoyl group (as for the carbamoyl group having a substituent, for example, an N-hydroxycarbamoyl group, an N-acylcarbamoyl group, an N-sulfonylcarbamoyl group, an N-carbamoylcarbamoyl group, a thiocarbamoyl group or an N-sulfamoylcarbamoyl group), a carbazoyl group, a carboxylic acid or a salt thereof, an oxalyl group, an oxamoyl group, a cyano group, a carbonimidoyl group, a formyl group, a hydroxyl group, an alkoxy group (containing a group having a repeating unit of an ethyleneoxy group or a propyleneoxy group), an aryloxy group, a heterocyclic oxy- group, an acyloxy group, an (alkoxy- or aryloxy-) carbonyloxy group, a carbamoyloxy group, a sulfonyloxy group,
an amino group, an (alkyl-, aryl- or heterocyclic-)amino group, an acylamino group, a sulfonamido group, a ureido group, a thioureido group, an N-hydroxyureido group, an imido group, an (alkoxy- or aryloxy-)carbonylamino group, a sulfamoylamino group, a semicarbazido group, a thiosemicarbazido group, a hydrazino group, an ammonio group, an oxamoylamino group, an N-(alkyl- or aryl-)sulfonylureido group, an N-acylureido group, an N-acylsulfamoylamino group, a hydroxyamino group, a nitro group, a heterocyclic group containing a quaternary nitrogen atom (for example, a pyridinio, an imidazolio group, a quinolinio group or an isoquinolinio group), an isocyano group, an imino group, a mercapto group, an (alkyl-, aryl- or heterocyclic-)thio group, an (alkyl-, aryl- or heterocyclic-)dithio group, an (alkyl- or aryl-) sulfonyl group, an (alkyl- or aryl-) sulfinyl group, a sulfo group or a salt thereof, a sulfamoyl group (as for a sulfamoyl group having a substituent, for example, an N-acylsulfamoyl group, anN-sulfonylsulfamoyl group) or a salt thereof, a phosphino group, a phosphinyl group, a phosphinyloxy group, a pliosphinylamino group and a silyl group.

The term "active methine group" as used herein is intended to indicate a methine group substituted by two electron-withdrawing groups, and the term "electron-withdrawing group" as used herein is intended to indicate an acyl group, an alkoxycarbonyl group, an aryloxycarbonyl group, a carbamoyl group, an alkylsulfonyl group, an arylsulfonyl group, a sulfamoyl group, a trifluoromethyl group, a cyano group, a nitro group and a carbonimidoyl group. The two electron-withdrawing groups may be linked to each other to form a ring structure. Further, the term "salt" as used herein indicates a salt with a cation of, for example, an alkaline metal, alkaline-earth metal or heavy metal, or with an organic cation such as an ammonium ion or phosphonium ion.

Among these substituents, examples of preferable substituents include a halogen atom (a fluorine atom, a chlorine atom, a bromine atom or an iodine atom), an alkyl group (a linear, branched or cyclic alkyl group, a polycyclic alkyl group, such as a bicycloalkyl group or an alkyl group containing an active methine group), an alkenyl group, an alkynyl group, an aryl group, a heterocyclic group (regardless of a position to be substituted), an acyl group, an alkoxycarbonyl group, an aryloxycarbonyl group, a heterocyclic oxycarbonyl group, a carbamoyl group, an N-hydroxycarbamoyl group, an N-acylcarbamoyl group, an N-sulfonylcarbamoyl group, an N-carbamoylcarbamoyl group, a thiocarbamoyl group, an N-sulfamoylcarbamoyl group, a carbazoyl group, an oxalyl group, an oxamoyl group, a cyano group, a carbonimidoyl group, a formyl group, a hydroxyl group, an alkoxy group (containing a group having a repeating unit of an ethyleneoxy group or a propyleneoxy group), an aryloxy group, a heterocyclic oxy- group, an acyloxy group, an (alkoxy- or aryloxy-) carbonyloxy group, a carbamoyloxy group, a sulfonyloxy group, an (alkyl-, aryl-or heterocyclic-) amino group, an acylamino group, a sulfonamido group, a ureido group, a thioureido group, an N-hydroxyureido group, an imido group, an (alkoxy- or aryloxy-)carbonylamino group, a sulfamoylamino group, a semicarbazido group, a thiosemicarbazido group, a hydrazino group, an ammonio group, an oxamoylamino group, an N- (alkyl- or aryl-) sulfonylureido group, an N-acylureido group, an N-acylsulfamoylamino group, a hydroxyamino group, a nitro group, a heterocyclic group containing a quaternary nitrogen atom (for example, a pyridinio, an imidazolio group, a quinolinio group or an isoquinolinio group), an isocyano group, an imino group, a mercapto group, an (alkyl-, aryl- or heterocyclic-) thio group, an (alkyl-, aryl- or heterocyclic-) dithio group, an (alkyl,- or aryl-) sulfonyl group, an '(alkyl- or aryl-)'sulfinyl group, a sulfo group or a salt thereof, a sulfamoyl group, an N-acylsulfamoyl group, an N-sulfonylsulfamoyl group or a salt thereof, a phosphino group, a phosphinyl group, a phosphinyloxy group, a phosphinylamino group and a silyl group. The term "active methine group" as used herein is intended to indicate a methine group substituted by two electron-withdrawing groups, and the term "electron-withdrawing group" as used herein is intended to indicate an acyl group, an alkoxycarbonyl group, an aryloxycarbonyl group, a carbamoyl group, an alkylsulfonyl group, an arylsulfonyl group, a sulfamoyl group, a trifluoromethyl group, a cyano group, a nitro group and a carbonimidoyl group.

Further preferably, for example, a halogen atom (a fluorine atom, a chlorine atom, a bromine group or an iodine group), an alkyl group (a linear, branched or cyclic alkyl group, a polycyclic group such as a bicycloalkyl group or an alkyl group may contain an active methine group), an alkenyl group, an alkenyl group, an aryl group and a heterocyclic group (regardless of a position to be substituted) are mentioned.

A ring to be formed by a bond formed between $R_1$ and $R_2$ and a -C-N bond in the general formula (I) may be a monocycle or a polycycle and, preferably, a monocycle of a 5- or 6-membered ring or a polycycle constituted by the 5- or 6-membered ring.

The above-described substituents may further be substituted by any one of the above-described substituents.

Amolecular weight of the compound represented by the general formula (I) is, preferably, 20 to 600 and, more preferably, 40 to 400.

Specific examples of such compounds represented by the general formula (I) are mentioned below; however,

the compounds are not limited thereto.

I-1

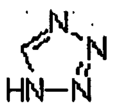

I-2

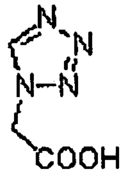

I-3

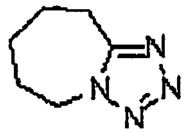

I-4

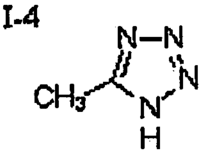

I-5

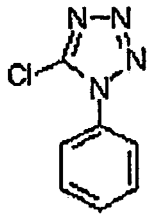

I-6

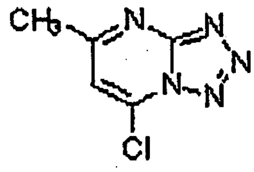

I-7

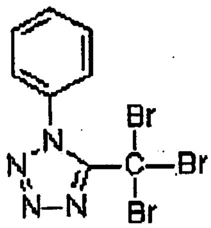

I-8

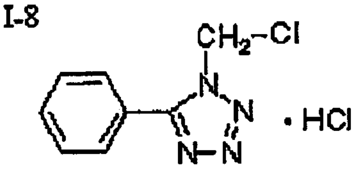

I-9

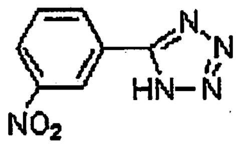

I-10

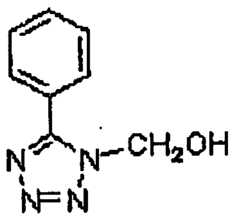

I-11

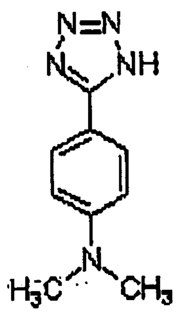

I-12

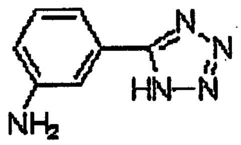

I-13

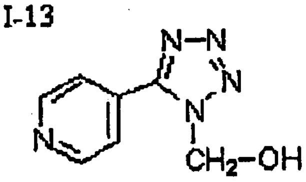

I-14

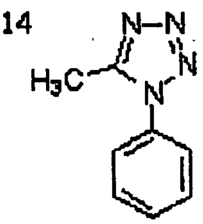

I-15

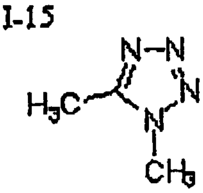

I-16

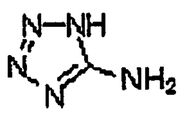

I-17

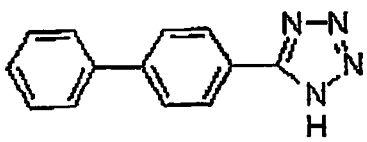

I-18

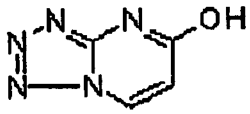

I-19

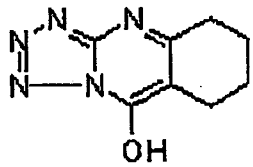

I-20

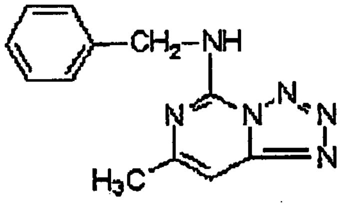

I-21

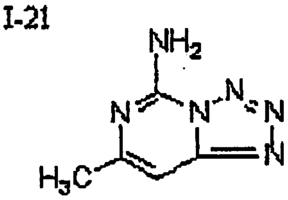

I-22

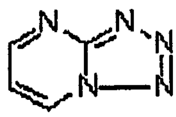

I-23

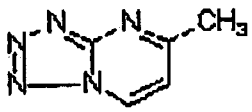

I-24

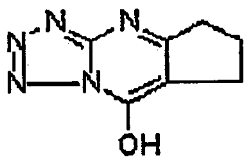

I-25

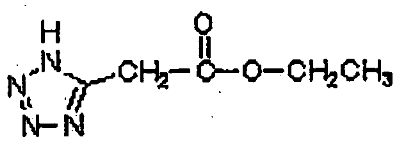

I-26

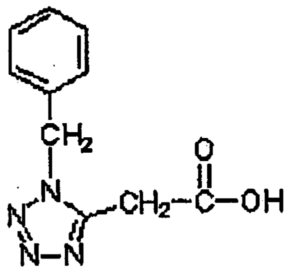

I-27

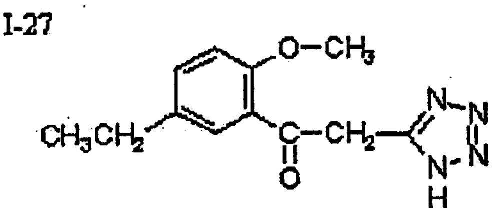

I-28

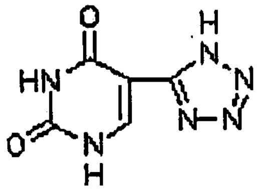

I-29

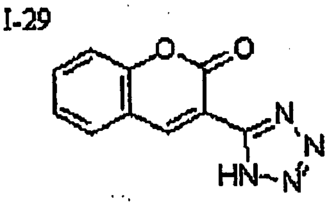

I-30

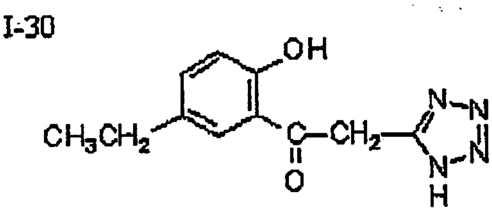

I-31

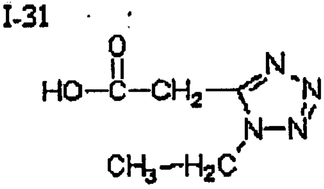

I-32

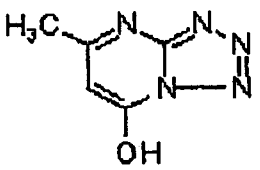

I-33

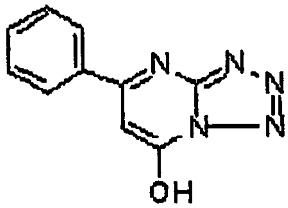

I-34

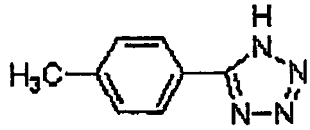

I-35

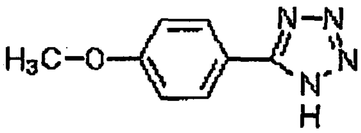

I-36

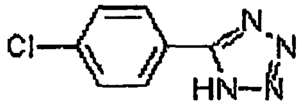

I-37

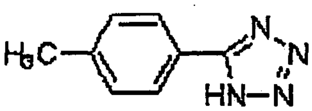

I-38

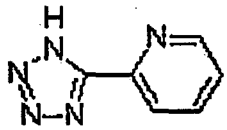

I-39

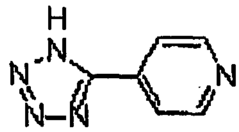

I-40

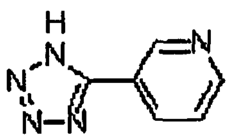

I-41

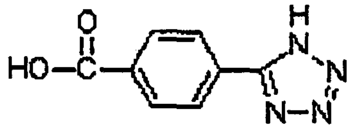

I-42

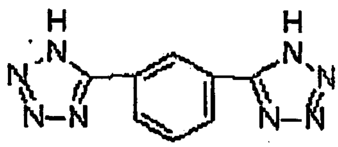

I-43

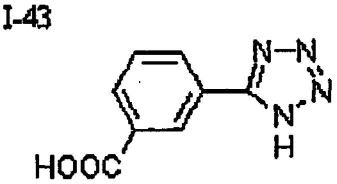

I-44

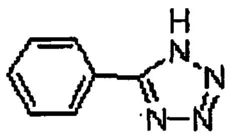

I-45

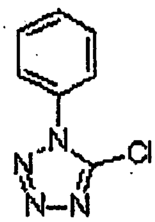

I-46

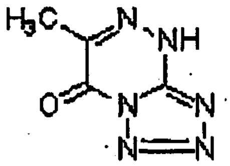

I-47

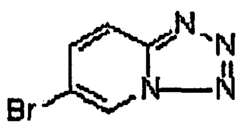

I-48

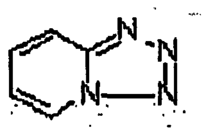

I-49

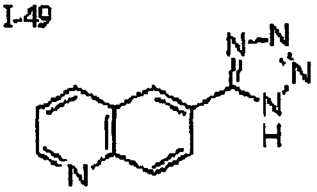

I-50

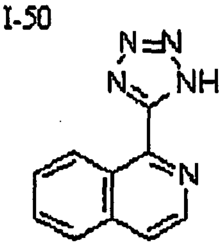

I-51

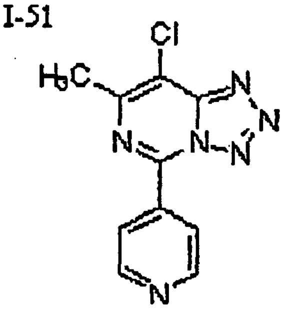

As for preferable compounds among compounds represented by the general formula (I), compounds I-1, 1-3, 1-4, I-10, I-15, I-21, I-22, I-23, I-41 and I-48 are mentioned. As for more preferable compounds, compounds I-1, I-4, I-15, I-22 and 1-23 are mentioned.

Further, the compounds represented by the general formula (I) not only can be produced in accordance with an ordinary method but also is available in the market.

An amount of the compound represented by the general formula (I) to be added is, as a total amount, preferably 0.0001 to 1.0 mol, more preferably 0.001 to 0.5 mol and, still more preferably, 0.01 to 0.1 mol in 1 L of the polishing solution for metal (that is, in a case in which the polishing solution for metal is diluted by water or an aqueous solution, the polishing solution refers to that which has been subjected to such dilution. Same holds true with "polishing solution for metal at the time of being used in polishing"). Namely, the amount of the compound represented by the general formula (I) to be added is, preferably, 1.0 mol or less in 1 L of the polishing solution for metal from the standpoint of preventing deterioration (non-effectiveness, decomposition) of an oxidizing agent and the compound represented by the general formula (I) and, also preferably, 0.0001 mol or more therein from the standpoint of obtaining a sufficient effect. Any one of a thiocyanate, thioethers, a thiosulfate and a methoion compound may simultaneously be used in a smaller amount than that of the compound represented by the general formula (I).

(Compound represented by the general formula (II))

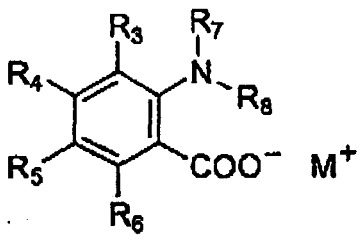

(II)

wherein $R_3$ to $R_8$ each independently represents a hydrogen atom or a substituent wherein any two adjacent to each other of $R_3$ to $R_8$ may form a ring by combining with each other; and $M^+$ represents a cation.

Such substituent as represented by $R_3$ to $R_8$ in the general formula (II) are not particularly limited. Examples of the substituents include articles described below.

Namely, mentioned are a halogen atom (a fluorine atom, a chlorine atom, a bromine atom or an iodine atom), an alkyl group (a linear, branched or cyclic alkyl group, a polycyclic alkyl group such as a bicycloalkyl group or an alkyl group containing an active methine group), an alkenyl group, an alkynyl group, an aryl group, a heterocyclic group (regardless of a position to be substituted), an acyl group, an alkoxycarbonyl group, an aryloxycarbonyl group, a heterocyclic oxycarbonyl group, a carbamoyl group (as for a carbamoyl group having a substituent, for example, an N-hydroxycarbamoyl group, an N-acylcarbamoyl group, an N-sulfonylcarbamoyl group, an N-carbamoylcarbamoyl group, a thiocarbamoyl group, an N-sulfamoylcarbamoyl group), a carbazoyl group, a carboxyl group and salts thereof, an oxalyl group, an oxamoyl group, a cyano group, a carbonimidoyl group, a formyl group, a hydroxyl group, an alkoxy group (containing a group having a repeating unit of an ethyleneoxy group or a propyleneoxy group), an aryloxy group, a heterocyclic oxy- group, an acyloxy group, an (alkoxy- or aryloxy-) carbonyloxy group, a carbamoyloxy group, a sulfonyloxy group, an amino group, an (alkyl-, aryl- or heterocyclic-)amino group, an acylamino group, a sulfonamido group, a ureido group, a thioureido group, an N-hydroxyureido group, an imido group, an (alkoxy- or aryloxy-)carbonylamino group, a sulfamoylamino group, a semicarbazido group, a thiosemicarbazido group, a hydrazino group, an ammonio group, an oxamoylamino group, an N- (alkyl- or aryl-) sulfonylureido group, an N-acylureido group, an N-acylsulfamoylamino group, a hydroxyamino group, a nitro group, a heterocyclic group containing a quaternary nitrogen atom (for

example, a pyridinio, an imidazolio group, a quinolinio group or an isoquinolinio group), an isocyano group, an imino group, a mercapto group, an (alkyl-, aryl- or heterocyclic-)thio group, an (alkyl-, aryl- or heterocyclic-)dithio group, an (alkyl- or aryl-) sulfonyl group, an (alkyl- or aryl-) sulfinyl group, a sulfo group or a salt thereof, a sulfamoyl group (as for a sulfamoyl group having a substituent, for example, an N-acylsulfamoyl group, an N-sulfonylsulfamoyl group) or a salt thereof, a phosphino group, a phosphinyl group, a phosphinyloxy group, a phosphinylamino group and a silyl group.

The term "active methine group" as used herein is intended to indicate a methine group substituted by two electron-withdrawing groups, and the term "electron-withdrawing group" as used herein is intended to indicate an acyl group, an alkoxycarbonyl group, an aryloxycarbonyl group, a carbamoyl group, an alkylsulfonyl group, an arylsulfonyl group, a sulfamoyl group, a trifluoromethyl group, a cyano group, a nitro group and a carbonimidoyl group. The two electron-withdrawing groups may be linked to each other to form a ring structure. Further, the term "salt" as used herein indicates a salt with a cation of, for example, an alkaline metal, alkaline-earth metal or heavy metal, or with an organic cation such as an ammonium ion or phosphonium ion.

These substituents may be substituted by any one of these substituents.

As for preferable substituents among these substituents, at least one of $R_3$ to $R_6$ represents other substituents, each having no substituent, than the alkyl group and, as for more preferable substituents, each of $R_7$ and $R_8$ represents a hydrogen atom. As for particularly preferable substituents, at least one of $R_3$ to $R_6$ represents the above-described electron-withdrawing group and, also, each of $R_7$ and $R_8$ represents a hydrogen atom.

Cations represented by $M^+$ are not particularly limited and examples of the cations include a hydrogen ion, an alkaline metal ion (for example, $Na^+$, $K^+$ or $Li^+$), an ammonium ion (for example, $NH_4^+$ or a quaternary ammonium ion) .

Amolecular weight of the compound represented by the general formula (II) is, preferably, 20 to 600 and, more preferably, 40 to 400.

Specific examples of such compounds represented by the general formula (II) are mentioned below; however, the compounds are not limited thereto.

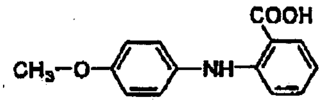
II-1

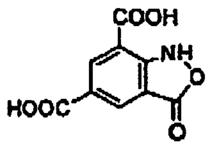
II-2

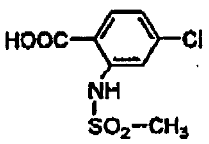
II-3

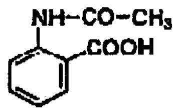
II-4

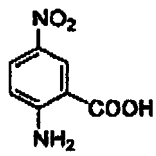
II-5

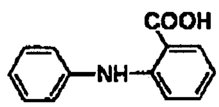
II-6

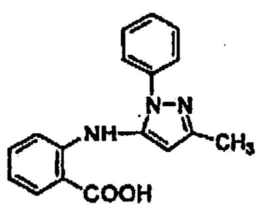
II-7

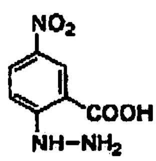
II-8

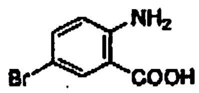 II-9

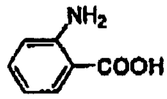 II-10

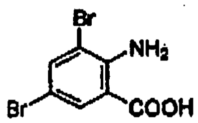 II-11

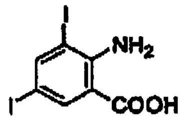 II-12

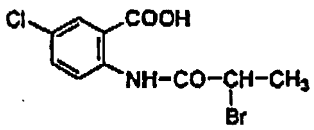 II-13

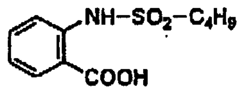 II-14

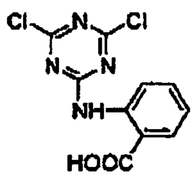 II-15

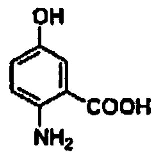 II-16

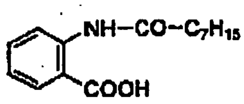 II-17

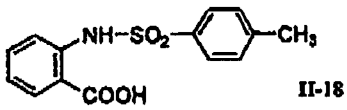 II-18

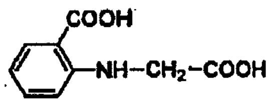 II-19

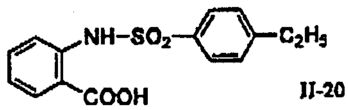 II-20

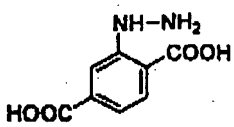 II-21

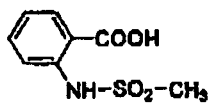 II-22

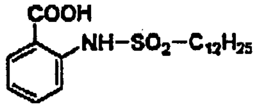 II-23

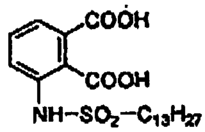 II-24

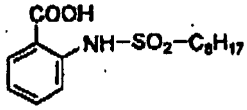 II-25

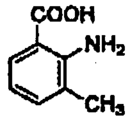 II-26

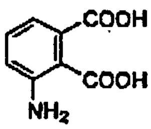 II-27

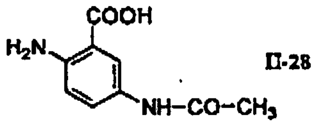 II-28

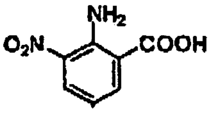 II-29

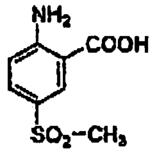 II-30

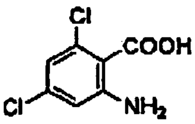 II-31

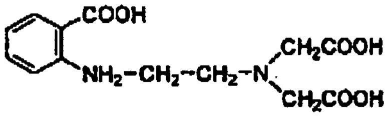

II-32

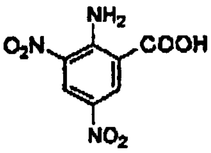 II-33

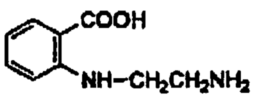 II-34

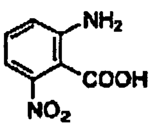 II-35

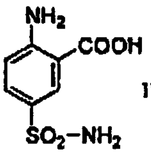 II-36

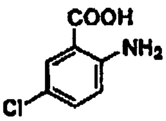 II-37

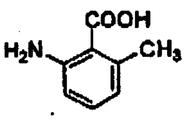 II-38

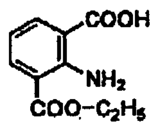 II-39

Further, salts of the above-illustrated compounds each formed by substituting a hydrogen atom in a carboxyl group with an alkaline metal ion such as $Na^+$, $K^+$ or $Li^+$, or an ammonium ion such as $NH_4^+$ or a quaternary ammonium ion are mentioned.

Among compounds represented by the general formula (II), compounds II-2, II-5, II-9, II-27, II-29, II-30, II-33, II-35 and II-37 are preferable and, thereamong, compounds II-5, II-9, II-27, II-29 and II-33 are more preferable. The compounds represented by the general formula (II) can be used either each individually or in combinations of two types or more.

Further, the compounds represented by the general formula (II) not only is available in the market but also can be produced in accordance with an ordinary method.

For example, the compound II-29 can be synthesized in accordance with a synthesis method as described in Synthesis (8), pp. 654 to 659 (1983); the compound II-37 can be synthesized in accordance with synthesis methods as described in Tetrahedron Letters, 51(7), pp. 1861 to 1866 (1995) and Tetrahedron Letters, 44(25), pp. 4741 to 4745 (2003). Other compounds than these compounds can also be synthesized in accordance with these synthesis methods.

An amount of the compound represented by the general formula (II) to be added is, as a total amount, preferably 0.0001 to 1.0 mol, more preferably 0.001 to 0.5 mol and, still more preferably, 0.01 to 0.1 mol in 1 L of the polishing solution for metal (that is, in a case in which the polishing solution for metal is diluted by water or an aqueous solution, the polishing solution refers to that which has been subjected to such dilution. Same holds true with "polishing solution for metal at the time of being used in polishing"). Namely, the amount of the compound represented by the general

formula (II) to be added is, preferably, 1.0 mol or less in 1 L of the polishing solution for metal from the standpoint of preventing deterioration (non-effectiveness, decomposition) of an oxidizing agent and the compound represented by the general formula (II) and, also preferably, 0.0001 mol or more therein from the standpoint of obtaining a sufficient effect. Any one of a thiocyanate, thioethers, a thiosulfate and a methoion compound may simultaneously be used in a smaller amount than that of the compound represented by the general formula (II).

(Oxidizing agent)

The polishing solution for metal according to the invention contains a compound (oxidizing agent) which can oxidize a subject metal to be polished. Examples of such oxidizers include hydrogen peroxide, a peroxide, a nitrate, an iodate, a periodate, a hypochlorite, a chlorite, a chlorate, a perchlorate, a persulfate, a bichromate, a permanganate, ozone water, a silver (II) salt and an iron (III) salt.

As for such iron (III) salts, for example, not only inorganic iron (III) salts such as iron (III) nitrate, iron (III) chloride, iron (III) sulfate and iron (III) bromide, but also an organic complex of iron (III) are preferably used.

In a case in which the organic complex of iron (III) is used, examples of complex-forming compounds which each constitute an iron (III) complex include acetic acid, citric acid, oxalic acid, salicylic acid, diethyl dithiocarbamic acid, succinic acid, tartaric acid, glycolic acid, glycine, alanine, aspartic acid, thioglycolic acid, ethylene diamine, trimethylene diamine, diethylene glycol, triethylene glycol, 1,2-ethanediol, malonic acid, glutaric acid, 3-hydroxybutyric acid, propionic acid, phthalic acid, isophthalic acid, 3-hydroxysalicylic acid, 3,5-dihydroxysalicylic acid, gallic acid, benzoic acid, maleic acid and salts thereof, a aminopolycarbonic acid and a salt thereof.

Examples of such aminopolycarbonic acids and salts thereof include ethylene diamine-N,N,N',N'-tetraacetic acid, diethylene triamine pentaacetic acid, 1,3-diaminopropane-N,N,N',N'-tetraacetic acid, ethylene diamine-N,N'-disuccinic acid (racemic form), ethylene diamine disuccinic acid (SS form), N-(2-carboxylatoethyl)-L-aspartic acid, N-(carboxymethyl)-L-aspartic acid, β-alanine diacetic acid, methyliminodiacetic acid, nitrilotriacetic acid, cyclohexane diamine tetraacetic acid, iminodiacetic acid, glycolether diamine tetraacetic acid, ethylene diamine 1-N, N'-diacetic acid, ethylene diamine orthohydroxyphenyl acetic acid, N,N-bis(2-hydroxybenzyl)ethylene diamine-N,N-diacetic acid and salts thereof. Types of counter salts are preferably alkaline metal salts and ammonium salts and, particularly preferably; ammonium salts.

Among these compounds, hydrogen peroxide, an iodate, a hypochlorite, a chlorate, an organic complex of iron (III). In a case in which the organic complex of iron (III) is used, examples of preferable complex-forming compounds include citric acid, tartaric acid, aminopolycarbonic acid (specifically, ethylene diamine-N,N,N',N'-tetraacetic acid , diethylene triamine pentaacetic acid, 1,3-diaminopropane-N,N,N',N'-tetraacetic acid, ethylene diamine-N,N'-disuccinic acid (racemic form), ethylene diamine disuccinic acid (SS form), N-(2-carboxylatoethyl)-L-aspartic acid, N-(carboxymethyl)-L-aspartic acid, β-alanine diacetic acid, methyliminodiacetic acid, nitrilotriacetic acid and iminodiacetic acid).

Among these oxidizing agents, hydrogen peroxide, and ethylene diamine-N,N,N',N'-tetraacetic acid, 1,3-diaminopropane-N,N,N',N'-tetraacetic acid and ethylene diamine disuccinic acid (SS form) of iron (III) are most preferred.

An amount of the oxidizing agent to be added is, preferably, 0.003 mol to 8 mol, more preferably 0.03 mol to 6 mol and, particularly preferably, 0.1 mol to 4 mol on the basis of an entire amount of 1000 ml made up with a metal oxidizing agent, a metal-oxide dissolving agent, a protective-film forming agent, a surfactant and water, at the time of using the polishing solution for metal in a state of being diluted with water or an aqueous solution. When such compounding amount is less than 0.003 mol, oxidation of the metal is insufficient and the CMP speed is low and, when it is over 8 mol, the polishing face is likely to be roughened.

In other words, an amount of the oxidizing agent to be added is, preferably, 0.003 mol to 8 mol, more preferably 0.03 mol to 6 mol and, particularly preferably, 0.7, mol to 4 mol in 1 L of the polishing solution for metal at the time of being used in polishing. Namely, the amount of the oxidizing agent to be added is, preferably, 0.003 mol or more from the standpoint of securing a sufficient oxidation and a high CMP speed and, also preferably, 8 mol or less from the standpoint of preventing the polished face from being roughened.

(Acid)

The polishing solution for metal according to the invention preferably further contains an acid. The term "acid" as used herein is intended to include a compound having a different structure from that of the oxidizing agent for oxidizing a metal and not to include the acid functioning as the above-described oxidizing agent. The acid has an action of promotion of oxidation or pH adjustment or acts as a buffering agent.

Examples of such acids include, within the range of such actions as described above, an inorganic acid, an organic acid, an amino acid. As for such inorganic acids, sulfuric acid, nitric acid, a boric acid, phosphoric acid and the like are mentioned. Among these inorganic acids, phosphoric acid is preferred.

According to the invention, particularly, it is preferable to allow the organic acid or the amino acid to be present

and more preferable to allow the amino acid to be present.

As for such organic acids, water-soluble ones are desirable. The acid which is more suitable is selected from the group consisting of: formic acid, acetic acid, propionic acid, butyric acid, valeric acid, 2-methyl butyric acid, n-hexanoic acid, 3,3-dimethyl butyric acid, 2-ethyl butyric acid, 4-methyl pentanoic acid, n-heptanoic acid, 2-methyl hexanoic acid, n-octanoic acid, 2-ethyl hexanoic acid, benzoic acid, glycolic acid, salicylic acid, glyceric acid, oxalic acid, malonic acid, succinic acid, glutaric acid, adipic acid, pimelic acid, maleic acid, phthalic acid, malic acid, tartaric acid, citric acid, lactic acid, and ammonium salts and alkaline metal salts thereof, and also sulfuric acid, nitric acid, ammonia, ammonium salts and mixtures thereof. Among these acids, formic acid, malonic acid, malic acid, tartaric acid and citric acid are favorable to a laminate film containing a metallic layer of at least one type of compound selected from among copper, a copper alloy, an oxide of copper and an oxide of copper alloy.

As for such amino acids, water-soluble ones are preferable. The amino acid which is more suitable is selected from the group consisting of: glycine, L-alanine, β-alanine, L-2-aminobutyric acid, L-norvaline, L-valine, L-leucine, L-norleucine, L-isoleucine, L-alloisoleucine, L-phenylalanine, L-proline, sarcosine., L-ornithine, L-lysine, taurine, L-serine, L-threonine, L-allothreonine, " L-homoserine, L-tyrosine, 3,5-diiodo-L-tyrosine, β-(3,4-dihydroxyphenyl)-L-alanine and L-thyroxine, 4-hydroxy-L-proline, L-cystine, L-methionine, L-ethionine, L-lanthionine, L-cystathionine, L-cystine, L-cysteic acid, L-aspartic acid, L-glutamic acid, S-(carboxymethyl)-L-cysteine, 4-aminobutyric acid, L-asparagine, L-glutamine, azaserine, L-arginine, L-canavanine, L-citruline, δ-hydroxy-L-lysine, creatine, L-kynurenine, L-histidine, 1-methyl-L-histidine, 3-methyl-L-histidine, ergothioneine, L-tryptophan, actinomycin C1, apamine, angiotensin I, angiotensin II and antipain.

Particularly, malic acid, tartaric acid, citric acid, glycine and glycolic acid are favorable from the standpoint of simultaneously maintaining a practical CMP speed and effectively suppressing an etching rate.

An amount of the acid to be added is, preferably, 0.0005 mol to 0.5 mol, more preferably 0.005 mol to 0.3 mol and, particularly preferably, 0.01 mol to 0.1 mol in 1 L of the polishing solution for metal at the time of being used in polishing. Namely, the amount of the acid to be added is, preferably, 0.5 mol or less from the standpoint of suppressing the etching and, also preferably, 0.0005 mol or more from the standpoint of obtaining a sufficient effect.

(Chelating agent)

It is preferable that the polishing solution for metal according to the invention optionally contains a chelating agent (namely, water softening agent), in order to reduce a detrimental influence of an polyvalent metal ion possibly being mixed.

The chelating agent is a water softening agent for genera purpose which is an anti-precipitating agent for calcium or magnesium. Examples of such chelating agents include nitrilotriacetic acid, diethylene triamine pentaacetic acid, ethylene diamine tetraacetic acid, N, N, N-trimethylene phosphonic acid, ethylene diamine- N,N,N',N'-tetramethylene sulfonic acid, transcyclohexane diamine tetraacetic acid, 1,2-diaminopropane tetraacetic acid, glycolether diamine tetraacetic acid, ethylene diamine orthohydroxyphenyl acetic acid, ethylene diamine disuccinic acid (SS form), N-(2-carboxylatoethyl)-L-aspartic acid, β-alanine diacetic acid, 2-phosphonobutane-1,2,4-tricarboxylic acid, 1-hydroxyethylidene-1,1-diphosphonic acid, N,N'-bis(2-hydroxybenzyl)ethylene diamine-N,N'-diacettic acid 1,2-dihydroxybenzene-4,6-disulfonic acid.

Two type or more of the chelating agents may optionally be simultaneously used.

An amount of the chelating agent to be added may be any amount so long as it is sufficient to block a metal ion such as a polyvalent metal ion. For example, the chelating agent is added in an amount of 0.0003 mol to 0.07 mol in 1 L of the polishing solution for metal at the time of being used in polishing.

[Additive]

Further, it is preferable that the polishing solution for metal according to the invention is added with any one of the following additives:

> ammonia; an amine, for example, an alkyl amine such as dimethyl amine, trimethyl amine, triethyl amine or propylene amine, ethylene diamine tetraacetic acid (EDTA), sodium diethyl dithiocarbamate or chitosan; an imine such as dithizone, cuproin (2,2'-biquinoline), neocuproin (2,9-dimethyl-1,10-phenanthroline), bathocuproin (2,9-dimethyl-4,7-diphenyl-1,10-phenanthroline) or cuprizone (biscyclohexanone oxalylhydrazone); an azole such as benzimidazole-2-thiol, 2-[2-(benzothiazolyl)]thiopropionic acid, 2-[2-(benzothiazolyl)]thiobutyric acid, 2-mercaptobenzothiazole, 1,2,3-triazole, 1,2,4-triazole, 3-amino-1H-1,2,4-triazole, benzotriazole, 1-hydroxybenzotriazole, 1-dihydroxypropyl benzotriazole, 2,3-dicarboxypropyl benzotriazole, 4-hydroxybenzotriazole, 4-carboxyl-1H-benzotriazole, 4-methoxycarbonyl-1H-benzotriazole, 4-butoxycarbonyl-1H-benzotriazole, 4-octyloxycarbonyl-1H-benzotriazole, 5-hexyl benzotriazole, N-(1,2,3-benzotriazolyl-1-methyl)-N-(1,2,4-triazole-1-methyl) -2-ethyl hexyl amine, tolyl

triazole, naphthotriazole or bis[(1-benzotriazolyl)methyl]phosphonic acid; a mercaptan such as nonyl mercaptan, dodecyl mercaptan, triazine thiol, triazine dithiol or triazine trithiol; anthranilic acid; aminotoluic acid; and quinaldic acid. Among these compounds, chitosan, ethylene diamine tetraacetic acid, L- tryptophan, cuprizone, triazine dithiol, benzotriazole, 4-hydroxybenzotriazole, 4-carboxyl-1H-benzotriazole butyl ester, tolyl triazole and naphthotriazole are favorable from the standpoint of simultaneously having a high CMP speed and a low etching rate.

An amount of any one of these additives to be added is, preferably, 0.0001 mol to 0.5 mol, more preferably 0.001 mol to 0.2 mol and, particularly preferably, 0.005 mol to 0.1 mol in 1 L of the polishing solution for metal at the time of being used in polishing. Namely, the amount to be added is, preferably, 0.0001 mol or more from the standpoint of suppressing the etching and, also preferably, 0.5 mol or less from the standpoint of preventing the CMP speed from being reduced.

[Surfactant and/or Hydrophilic polymer]

It is preferable that the polishing solution for metal according to the invention contains at least one of a surfactant and a hydrophilic polymer. The surfactant and the hydrophilic polymer each have an effect of reducing a contact angle with a face to be polished and, then, an effect of promoting a uniform polishing. At least one of the surfactant and the hydrophilic polymer to be favorably used is selected from the group consisting of: anionic surfactants such as a carboxylate, for example, soap, an N-acylamino acid salt, a polyoxyethylene or polyoxypropylene alkyl ether carboxylate or an acylated peptide; a sulfonate, for example, an alkyl sulfonate, an alkylbenzene or alkylnaphthalene sulfonate, a naphthalene sulfonate, a sulfosuccinate, an $\alpha$-olefin sulfonate or an N-acylsulfonate; a sulfuric acid ester salt, for example, a sulfated oil, an alkyl sulfated oil, an alkyl ether sulfated oil, a polyoxyethylene or polyoxypropylene alkyl allyl ether sulfate or an alkyl amide sulfate; and a phosphoric acid ester salt, for example, an alkyl phosphate, polyoxyethylene or polyoxypropylene alkyl allyl ether phosphate, cationic surfactants such as an aliphatic amine salt, an aliphatic quaternary ammonium salt, benzalkonium chloride, benzethonium chloride, a pyridinium salt and an imidazolinium salt, amphoteric surfactants such as a carboxybetaine type, an aminocarboxylate, imidazolinium betaine, lecithin and an alkyl amine oxide, nonionic surfactants such as an ether type, for example, a polyoxyethylene alkyl and alkyl phenyl ether, an alkyl allyl formaldehyde condensed polyoxyethylene ether, a polyoxyethylene polyoxypropylene block polymer or a polyoxyethylene polyoxypropylene alkyl ether; an ether ester type, for example, a polyoxyethylene ether of glycerin ester, a polyoxyethylene ether of sorbitan ester or a polyoxyethylene ether of sorbitol ester; an ester type, for example, a polyethylene glycol fatty acid ester, a glycerin ester, a polyglycerin ester, a sorbitan ester, a propylene glycol ester or a sucrose ester; and a nitrogen-containing type, for example, a fatty acid alkanol amide, a polyoxyethylene fatty acid amide or polyoxyethylene alkyl amide.

Further, fluorine-type surfactants can be mentioned.

Still further, as for other surfactants, hydrophilic compounds, hydrophilic polymers and the like, esters such as a glycerin ester, a sorbitan ester, methoxyacetic acid, ethoxyacetic acid, an ester of 3-ethoxypropionic acid and alanine ethyl ester; ethers such as polyethylene glycol, polypropylene glycol, polytetramethylene glycol, a polyethylene glycol alkyl ether, a polyethylene glycol alkenyl ether, an alkyl polyethylene glycol, an alkyl polyethylene glycol alkyl ether, an alkyl polyethylene glycol alkenyl ether, an alkenyl polyethylene glycol, an alkenyl polyethylene glycol alkyl ether, an alkenyl polyethylene glycol alkenyl ether, a polypropylene glycol alkyl ether, a polypropylene glycol alkenyl ether, an alkyl polypropylene glycol, an alkyl polypropylene glycol alkyl ether, an alkyl polypropylene glycol alkenyl ether, an alkenyl polypropylene glycol, an alkenyl polypropylene glycol alkyl ether and an alkenyl polypropylene glycol alkenyl ether; polysaccharides such as alginic acid, pectinic acid, carboxymethyl cellulose, curdlan and pullulan; amino acid salts such as glycine ammonium salt and glycine sodium salt; polycarboxylic acids and salts thereof such as polyaspartic acid, polyglutamic acid, polylycine, lycine and polymalic acid, polymethacrylic acid, ammonium polymethacrylate, sodium polymethacrylate, polyamic acid, polymaleic acid, polyitaconic acid, polyfumaric acid, poly(p-styrene carboxylic acid), polyacrylic acid, polyacrylamide, aminopolyacrylamide, ammonium polyacrylate, sodium polyacrylate, a polyamic acid ammonium salt, a polyamic acid sodium salt and polyglyoxylic acid; vinyl-type polymers such as polyvinyl alcohol, polyvinyl pyrrolidone and polyacrolein; sulfonic acids and salts thereof such as ammonium methyl taurate, sodium methyl taurate, sodium methyl sulfate, ammonium ethyl sulfate, ammonium butyl taurate, sodium vinyl sulfonate, sodium 1-ally sulfonate, sodium 2-sllyl sulfonate, sodium methoxy methyl sulfonate, ammonium ethoxy methyl sulfonate, sodium 3-ethoxy propyl sulfonate, sodium methoxy methyl sulfonate, ammonium ethoxy methyl sulfonate and sodium sulfosuccinate; and amides such as propionamide, acrylamide, methyl urea, nicotinamide, succinamide, and sulfanyl amide.

However, when a basic substance to be applied is a silicon substrate for a semiconductor integrated circuit or the like, since contamination by an alkaline metal, an alkaline earth metal, a halide or the like is not desirable and an acid or an ammonium salt thereof is favorable. However, in a case in which the base substance is glass basic substance, this case is not necessarily limited to these compounds. Among above-exemplified compounds, cyclohexanol, ammonium polyacrylate, polyvinyl alcohol, succinamide, polyvinyl pyrrolidone, polyethylene glycol and a polyoxyethylene polyoxypropylene block copolymer are more preferred.

An amount of at least one of the surfactant and the hydrophilic polymer to be added is preferably 0.001 to 10 g, more preferably 0.01 to 5 g and, particularly preferably, 0.1 to 3 g on the basis of an entire amount of 1000 ml made up with a metal oxidizing agent, a metal-oxide dissolving agent, a protective-film forming agent, a surfactant and water, at the time of using the polishing solution for metal in a state of being diluted with water or an aqueous solution. When such compounding amount is less than 0.001 g, an addition effect of the surfactant is not likely to be exhibited and, when it is more than 10 g, the CMP speed is likely to be reduced. Further, a weight average molecular weight of at least one of the surfactant and the hydrophilic polymer is, preferably, 500 to 100000 and, particularly preferably, 2000 to 50000.

In other words, an amount of at least one of the surfactant and the hydrophilic polymer to be added is, as an entire amount, preferably 0.001 to 10 g, more preferably 0.01 to 5 g and, particularly preferably, 0.1 to 3 g in 1 L of the polishing solution for metal at the time of being used in polishing. Namely, the amount of at least one of the surfactant and the hydrophilic polymer to be added is, preferably, 0.001 g or more from the standpoint of obtaining a sufficient effect and, also preferably, 10 g or less from the standpoint of preventing the CMP speed from being reduced.

[Alkaline agent and Buffering agent]

The polishing solution according to the invention can optionally contain an alkaline agent for adjusting a pH value and, further, a buffering agent from the standpoint of suppressing a fluctuation of the pH value.

As for such alkaline agents and the buffering agents, non-metallic alkaline agents such as organic ammonium hydroxides, for example, ammonium hydroxide and tetramethyl ammonium hydroxide; and alkanol amines, for example, diethanol amine, triethanol amine and triisopropanol amine, alkaline metallic hydroxides such as sodium hydroxide, potassium hydroxide and lithium hydroxide, a carbonate, a phosphate, a borate, a tetraborate, a hydroxybenzoate, a glycine salt, an N,N-dimethyl glycine salt, a leucine salt, an isoleucine salt, a guanine salt, a 3,4-dihyroxyphenyl alanine salt, an alanine salt, an aminobutyrate, a 2-amino-2-methyl-1, 3-propane diol salt, a valine salt, a praline salt, a trishydroxyaminomethane salt and a lycine and the like can be used.

Specific examples of the alkaline agents and the buffering agents include sodium hydroxide, potassium hydroxide, lithium hydroxide, sodium carbonate, potassium carbonate, sodium bicarbonate, potassium bicarbonate, trisodium phosphate, tripotassium phosphate, disodium phosphate, dipotassium phosphate, sodium borate, potassium borate, sodium tetraborate (borax), potassium tetraborate, sodium o-hydroxybenzoate (sodium salicylate), potassium o-hydroxybenzoate, sodium 5-sulfo-2-hydroxybenzoate (sodium 5-sulfosalicylate), potassium 5-sulfo-2-hydroxybenzoate (potassium 5-sulfosalicylate) and ammonium hydroxide.

As for particularly preferable alkaline agents, ammonium hydroxide, potassium hydroxide, lithium hydroxide and tetramethyl ammonium hydroxide are mentioned.

As for an entire amount of the alkaline agent and the buffering agent to be added, any amount is permissible so long as a pH value is maintained in a preferable range and it is, preferably, 0.0001 mol to 1.0 mol and, more preferably, 0.003 mol to 0.5 mol in 1 L of the polishing solution at the time of being used in polishing.

The pH value of the polishing solution at the time of being used in polishing is, preferably, 2 to 14, more preferably 3 to 12 and, most preferably, 3.5 to 8. In the stated ranges, the polishing solution for metal according to the invention performs a particularly excellent effect.

According to the invention, depending on solubility to and reactivity with a polishing surface, solubility of a polishing metal, electrochemical properties of a face to be polished, a dissociation state of a compound functional group, stability as a solution and the like, it is preferable to timely set a compound species, an addition amount and the pH value.

[Abrasive grain]

The polishing solution for metal according to the invention preferably contains abrasive grains. Examples of preferable grains include silica (precipitated silica, fumed silica, colloidal silica, synthetic silica), ceria, alumina, titania, zirconia, germania, manganese oxide, silicon carbide, polystyrene, polyacrylic articles and palyterephthalates.

An average grain diameter of the abrasive grains is, preferably, 5 to 1000 nm and, particularly preferably, 10 to 200 nm.

An amount of the abrasive grains to be added is, based on the entire mass of the polishing solution for metal at the time of being used, preferably, 0.01 to 20% by mass and, more preferably, 0.05 to 5% by mass. When the amount is less than 0.01% by mass, an effect of containing the abrasive grains can not be exhibited and, when it is more than 20% by mass the polishing rate by the CMP is saturated and, even though the abrasive grains are further added, an increase of the polishing rate can not be noticed.

In a case in which the abrasive grains are not contained or the abrasive grains having a concentration of less than 0.01% by mass are contained, it has been found that properties of the polishing rate and dishing are improved by allowing a pH value to be, preferably, 3.5 or more and, particularly, 4.0 or more. In this case, it is preferable to add the

hydrophilic polymer such as polyacrylic acid and an amount thereof to be added is, ordinarily, 0.0001 to 5% by mass and, preferably, 0.01 to 0.5% by mass. Incidentally, "% by mass" means "% by weight" in this specification.

[Wiring metal raw material]

According to the invention, the semiconductor which is an object to be polished is preferably an LSI containing a wiring having at least one of a copper metal and a copper alloy and, particularly preferably that having the wiring containing the copper alloy. The copper alloy containing silver is preferred. An amount of silver to be contained in the copper alloy is preferably 40% by mass or less, more preferably 10% by mass or less, still more preferably 1% by mass or less. Further, the copper alloy containing silver in the range of from 0.00001 to 0.1% by mass perform a particularly excellent effect.

[Wiring thickness]

According to the invention, the semiconductor which is an object to be polished is preferably an LSI containing a wiring having a half pitch, in a DRAM device system, of preferably 0.15 μm or less, more preferably 0.10 μm or less and, still more preferably, 0.08 μm or less and, in an MPU device system, of 0.12 μm or less, more preferably 0.09 μm or less and, still more preferably, 0.07 μm or less. The polishing solution according to the invention performs a particularly excellent effect on these LSI's.

[Barrier metal]

According to the invention, it is preferable to provide a barrier layer for preventing diffusion of copper between the wiring containing at least one of copper and a copper alloy and an inter-layer insulating film. For the barrier layer, a material having a low resistance is preferred and, particularly, TiN, TiW, Ta, TaN, W and WN are preferable. Among these materials, Ta and TaN are particularly preferable.

As for the interlayer insulating film, a thin film of the insulating material having a low dielectric constant. A favorable insulating material is a material having a dielectric constant of 3.0 or less and, more preferably, 2.8 or less. Examples of favorable materials each having a low dielectric constant include Black Diamond (available from Applied Materials, Inc.), FLARE (available from Honeywell Electronic Material), SILK (available from The Dow Chemical Company), CORAL (available from Novellus Systems, Inc.), LKD (available from JSR Corporation) and HSG (available from Hitachi Chemical Co., Ltd.).

[Polishing method]

In regard to the polishing solution for metal, there are a case in which the polishing solution for metal is firstly prepared as a concentrated polishing solution for metal and, then, allowed to be a solution for actual use by being diluted with water at the time of being used, another case in which components are mixed with one another to be in a form of an aqueous solution as described below and the resultant aqueous solution is allowed to be a solution for actual use by being optionally diluted with water at the time of being used and still another case in which the polishing solution for metal is prepared as a solution for actual use. A polishing method using the polishing solution for metal according to the invention is applicable to any one of these cases and performs polishing by firstly supplying the polishing solution to a polishing pad arranged on a polishing platen, next allowing the polishing pad to come in contact with a face to be polished and, then, relatively moving the face to be polished and the polishing pad.

As for an apparatus to perform polishing, an ordinary polishing apparatus having the polishing platen (attached with a motor capable of varying rotations) on which a holder for holding the semiconductor or the like having a face to be polished and the polishing pad adhere can be used. As for the polishing pad, an ordinary non-woven fabric, foamed polyurethane, a porous fluorocarbon resin and the like can be used and are not particularly limited. Although there is no limitation on a polishing condition, a rotation speed of the polishing platen is preferably as low as 200 rpm or less to prevent the substrate from being flied out. A pushing pressure of the semiconductor substrate having the face to be polished (film to be polished) to the polishing pad is, preferably, 5 to 500 g/cm$^2$ and, in order to satisfy a wafer in-plane uniformity of the polishing rate and flatness of a pattern, is, more preferably, 12 to 240 g/cm$^2$.

During the polishing, the polishing solution for metal is continuously supplied to the polishing pad by a pump or the like. Although an amount thereof to be supplied is not limited, it is preferable that a surface of the polishing pad is always covered with the polishing solution. The semiconductor substrate after being polished is sufficiently washed with flowing water. Then, after a water droplet adhering on the semiconductor substrate is removed by using a spin dryer or the like, the semiconductor substrate is dried. In the polishing method according to the invention, an aqueous solution for use in dilution is same solution as described below. The aqueous solution is water which has previously been added

with at least one of the oxidizing agent, the acid, the additive and the surfactant. A sum of components contained in the aqueous solution and those contained in the polishing solution for metal to be diluted is allowed to be components at the time of polishing using the polishing solution for metal. In a case in which it is used by being diluted with the aqueous solution, a component which is hard to be dissolved can be compounded in a form of the aqueous solution, to thereby prepare the polishing solution for metal which has further been concentrated.

As for a method for diluting the thus-concentrated polishing solution for metal by adding water or the aqueous solution thereto, there is a method in which a piping that supplies the concentrated polishing solution for metal and a piping that supplies water or the aqueous solution are combined with each other in the midway and, then, the concentrated polishing solution for metal and water or the aqueous solution are mixed with each other and, thereafter, the resultant diluted polishing solution for metal is supplied to the polishing pad. For such mixing as described above, a conventional method, for example, a method in which both solutions are allowed to pass through a narrow path under pressure, collide with each other and, then, be mixed with each other, another method in which filling materials such as glass tubes are packed in the piping and, then, merging and separation of streams of the solutions are repeated, or still another method in which an impeller which is driven by a motor is provided in the piping can be adopted.

A supply rate of the polishing solution for metal is preferably 10 to 1000 mL/min and, in order to satisfy a wafer in-plane uniformity of the polishing rate and flatness of a pattern, is, more preferably, 170 to 800 mL/min.

Further, as for a method in which the concentrated polishing solution for metal is diluted by water, the aqueous solution or the like and, then, the polishing is performed, there are a method in which the piping which supplies the polishing solution for metal and the piping which supplies water or the aqueous solution are each independently provided and, then, a given amount of each of the solutions is supplied to the polishing pad and, thereafter, the both solutions are mixed with each other by a relative movement of the polishing pad and the face to be polished, to thereby performing polishing, and another method in which a given amount of each of the concentrated polishing solution for metal and water or the aqueous solution is filled in a container and the both solutions are mixed and, then, the polishing solution resultant from such mixing is supplied to the polishing pad, to thereby performing polishing.

As for still another polishing method according to the invention, there is a method in which components which are necessarily contained in the polishing solution for metal are divided to two constituents and, when they are used, they are each diluted with water or the aqueous solution and, then, supplied to the polishing pad on the polishing platen and, thereafter, the polishing pad is allowed to come in contact with the face to be polished and, subsequently, polishing is performed by allowing the face to be polished and the polishing pad to be relatively moved to each other.

For example, the oxidizing agent is allowed to be one constituent (A) and the acid, the additive, the surfactant and water are allowed to be another constituent (B) and, at the time of using these constituents (A) and (B), they are diluted with water or the aqueous solution and, then, used.

Further, additives each having a low solubility are divided to constituents (A) and (B) and, then, the oxidizing agent, the additive and the surfactant are allowed to be one constituent (A) and the acid, the additive, the surfactant and water are allowed to be another constituent (B) and, at the time of using these constituents (A) and (B), they are diluted with water or the aqueous solution and, then, used. On this occasion, three pipings for supplying the constituent (A), the constituent (B) and water or the aqueous solution, respectively, are necessary and, as for a dilute-mixing method, there is a method in which the three pipings are combined into one piping which supplies the solution to the polishing pad and, then, such dilute-mixing is performed in the piping. In this method, it is also possible to firstly combine two pipings with each other and, then, the remaining one piping with the resultant piping.

For example, it is a method in which a constituent which is hard to be dissolved and another constituent are mixed with each other and, then, by allowing a mixing path to be long, a dissolving time period is secured and, thereafter, another piping for water and the aqueous solution is combined. As for other methods, as described above, there is a method in which three pipings are led to the polishing pad and, then, mixing is performed by a relative movement of the polishing pad and the face to be polished and another method in which three constituents are mixed in a container and, then, the resultant diluted polishing solution for metal is supplied to the polishing pad. In the above-described polishing method, one constituent containing the oxidizing agent is allowed to be at 40°C or less and the other constituent is heated to a temperature in the range of from room temperature to 100°C and, further, at the time the one constituent is used after diluted with the other constituent, or water or the aqueous solution, the resultant mixture thus diluted can also be arranged to be 40°C or less. Since the temperature is high, the solubility becomes high and, accordingly, this method is a favorable method for increasing the solubility of the raw material having a low solubility of the polishing solution for metal.

The raw material in which other components than the oxidizing agent are heated to a temperature in the range of from room temperature to 100°C comes to be precipitated in the solution when the temperature is lowered and, therefore, when such components as lowered in temperature are used, it is necessary to previously heat to allow the resultant precipitate to be dissolved. On this occasion, a measure of transferring a constituent solution which has been subj ected to heating and dissolving, or a measure in which the solution containing the precipitate is stirred and, then, transferred while heating the piping to dissolve the precipitate therein can be adopted. When the temperature of the one

constituent in which the heated components contains the oxidizing agent is raised to 40°C or more, there is a fear of decomposing the oxidizing agent and, therefore, when the thus-heated constituent and the one constituent containing oxidizing agent for cooling the thus-heated constituent are mixed with each other, the temperature is arranged to be 40°C or less.

Further, according to the invention, as described above, the components of the polishing solution for metal may be divided in to halves and, then, supplied to the face to be polished. On this occasion, the components are divided into components containing an oxide and other components containing the acid and, then, supplied. Further, the polishing solution for metal is allowed to be a concentrated solution and, then, supplied to the face to be polished separated from diluting water.

[Pad]

The polishing pad may either have a non-foam structure or a foam structure. The former can use a rigid synthetic resin bulk material such as a plastic board. In the latter, there are three types, that is, an independent foam (dry foaming type), a continuous foam (wet foaming type) and a two-layer complex (laminate type) and, thereamong, the two-layer complex (laminate type) is particularly favorable. The foam may either be uniform or non-uniform.

Further, abrasive grains for use in polishing (for example, ceria, silica, alumina or a resin) may be contained therein. Still further, the above-described foams may either be a flexible type or a rigid type and there is no difference in preference therebetween. In the laminate type, it is preferable to use layers having different hardness from one another. As for materials thereof, a non-woven fabric, a synthetic leather, a polyamide, polyurethane, a polyester, a polycarbonate and the like are preferred. Further, a face thereof which comes in contact with the face to be polished may be subjected to treatments of, for example, lattice-shaped grooves, holes, cocentric grooves and helical grooves.

[Wafer]

The wafer which is a target to be subjected to the CMP by the polishing solution for metal according to the invention has a diameter of, preferably, 200 mm or more and, particularly preferably, 300 mm or more. When the diameter is 300 mm or more, the invention exhibits a remarkable effect.

Hereinafter, the features of the chemical mechanical polishing method according to the second invention will be described in detail.

(Polishing operation and method)

In regard to the polishing solution for metal containing the metal oxidizing agent, the metal-oxide dissolving agent, the protective-film forming agent, the surfactant and water, there are a case in which the polishing solution for metal is firstly prepared as a concentrated polishing solution for metal and, then, allowed to be a solution for actual use by being diluted with water at the time of being used, another case in which components are mixed with one another to be in a form of an aqueous solution as described below and the resultant aqueous solution is allowed to be a solution for actual use by being optionally diluted with water at the time of being used and still another case in which the polishing solution for metal is prepared as a solution for actual use. A polishing method using the polishing solution for metal according to the invention is applicable to any one of these cases and performs polishing by firstly supplying the polishing solution to a polishing pad arranged on a polishing platen, next allowing the polishing pad to come in contact with a face to be polished and, then, relatively moving the face to be polished and the polishing pad.

As for an apparatus to perform polishing, an ordinary polishing apparatus having the polishing platen (attached with a motor capable of varying rotations) on which a holder for holding the semiconductor or the like having a face to be polished and the polishing pad adhere can be used.

<Average relative speed>

Since a relative movement between the polishing face and the face to be polished of the polishing pad varies depending on sites due to a rotary polishing, it is appropriate to describe the relative movement in terms of an average relative movement speed (hereinafter, referred to also as "average relative speed" in short).

The average relative speed is determined as an average value of an average movement speed of a straight line passing through the center of the face to be polished to a diameter direction.

For example, when the face to be polished and the polishing face are both a rotating body, a distance between rotating centers of both rotating bodies is defined as an inter-center distance L. The relative movement speed of the face to be polished on a line connecting both centers is determined and the thus-determined relative movement speed is defined as an average relative speed. FIG. 1 is a plan view of a rotary polishing face containing the polishing face

and the face to be polished for explaining the average relative speed. In FIG. 1, a distance between a center B of the face to be polished and a center O of the polishing face is denoted as L[m], a diameter of the polishing face is defined as Rp[m], a diameter of the face to be polished is defined as Rw[m], an angle speed of the polishing face is defined as ωp[rad/s] and an angle speed of the face to be polished is defined as ωw[rad/s].

Relative movement speeds Va, Vb and Vc at a point A, a point B and a point C, respectively, at the time of Rp>Rw is expressed by the following formulae:

$$A: Va = (L - Rw)*\omega p + Rw*\omega w;$$

$$B: Vb = L*\omega p; \text{ and}$$

and

$$C: Vc = (L + Rw)*\omega p - Rw*\omega w.$$

In the same manner as above, a speed distribution of the face to be polished to a diameter direction A-C is determined and, then, a sum of such speeds is divided by the number of measurement sites, to thereby obtain an average value as the average relative movement speed.

According to the second invention, the average relative speed is, preferably, 0.5 to 5.0 m/s, more preferably 1.0 to 3.5 m/s and, particularly preferably, 1.5 to 3.0 m/s.

<Contact pressure>

According to the invention, a value obtained by dividing a force to be applied on a contact portion between the polishing face and the face to be polished by a contact area thereof is defined as a contact pressure. For example, when an entire face of the face to be polished having a diameter of Ø200 mm is pressed against a polishing face having a diameter of Ø600 mm with a force of 400 N, the contact area comes to be $(0.1)^2\pi=3.14\times10^{-2}$ $m^2$ and, then, the contact pressure comes be $400/(3.14\times10^{-2})$=12,732 Pa.

The contact pressure to be applied to the CMP method according to the second invention is 1000 to 25000 Pa, preferably 2000 to 17500 Pa and, more preferably, 3500 to 14000 Pa. As described above, it is a characteristic of the second invention that, even when the polishing is performed under a low pressure, a loss of the polishing rate comes to be small by interposing the compound represented by the general formula (I) or (II).

<Particularly preferable polishing method and apparatus according to the second invention>

Among metal wiring CMP processes of the semiconductor substrate, a particularly preferred embodiment according to the invention is an embodiment of a polishing process in which abrasive grains are contained in a metal polishing solution and another embodiment of a polishing process in which the abrasive grains are not contained in the polishing solution but is contained in a polishing face.

Examples of apparatuses for use in these embodiments include Mirra Mesa CMP, Reflexion CMP (available from Applied Materials, Inc.), FREX200, FREX300 (available from Ebara Corporation), NPS3301, NPS2301 (available from Nikon Corporation), A-FP-310A, A-FP-210A (available from Tokyo Seimitsu Co., Ltd.), 2300 TERES (available from Lam Research Corp.) and Momentum (SpeedFam-IPEC, Inc.).

<Polishing condition and others>

The CMP method according to the invention will further be described.

During the polishing, the polishing solution for metal is continuously supplied to the polishing pad by a pump or the like. Although an amount thereof to be supplied is not limited, it is preferable that a surface of the polishing pad is always covered with the polishing solution. The semiconductor substrate after being polished is sufficiently washed with flowing water. Then, after a water droplet adhering on the semiconductor substrate is removed by using a spin dryer or the like, the semiconductor substrate is dried. In the polishing method according to the invention, an aqueous solution

for use in dilution is same solution as described below. The aqueous solution is water which has previously been added with at least one of the oxidizing agent, the metal-oxide dissolving agent, the protective-film forming agent and the surfactant. A sum of components contained in the aqueous solution and those contained in the polishing solution for metal to be diluted is allowed to be components at the time of polishing using the polishing solution for metal. In a case in which it is used by being diluted with the aqueous solution, a component which is hard to be dissolved can be compounded in a form of the aqueous solution, to thereby prepare the polishing solution for metal which has further been concentrated.

As for a method for diluting the thus-concentrated polishing solution for metal by adding water or the aqueous solution thereto, there is a method in which a piping that supplies the concentrated polishing solution for metal and a piping that supplies water or the aqueous solution are combined with each other in the midway and, then, the concentrated polishing solution for metal and water or the aqueous solution are mixed with each other and, thereafter, the resultant diluted polishing solution for metal is supplied to the polishing pad. For such mixing as described above, a conventional method, for example, a method in which both solutions are allowed to pass through a narrow path under pressure, collide with each other and, then, be mixed with each other, another method in which filling materials such as glass tubes are packed in the piping and, then, merging and separation of streams of the solutions are repeated, or still another method in which an impeller which is driven by a motor is provided in the piping can be adopted.

A supply rate of the polishing solution for metal is preferably 10 to 1000 mL/min and, more preferably, 50 to 500 mL/min.

Further, as for a method in which the concentrated polishing solution for metal is diluted by water or the aqueous solution and, then, the polishing is performed, a method in which the piping which supplies the polishing solution for metal and the piping which supplies water or the aqueous solution are each independently provided and, then, a given amount of each of the solutions is supplied to the polishing pad and, thereafter, the both solutions are mixed with each other by a relative movement of the polishing pad and the face to be polished can be used. There is another method in which a given amount of each of the concentrated polishing solution for metal and water or the aqueous solution is filled in a container and the both solutions are mixed and, then, the polishing solution resultant from such mixing is supplied to the polishing pad.

[EXAMPLES]

Hereinafter, the first invention is described in detail with reference to Examples and is not limited thereto.

<Example 1-1>

A polishing solution as described below was prepared, subjected to a polishing test and evaluated.

(Preparation of polishing solution)

| | |
|---|---|
| Compound (I-1) | 0.1 g/L |
| Hydrogen peroxide (oxidizing agent) | 10 g/L |
| Glycine (acid) | 8 g/L |
| Colloidal silica (average grain diameter 40 nm) | 40 g/L |
| Entire volume made up to with purified water | 1000 mL |
| pH (adjusted with aqua ammonia and sulfuric acid) | 7.0 |

(Polishing test)

Substrate: silicon substrate on which a film of copper/silver alloy having a thickness of 1 μm is formed
Polishing pad: IC1400K-Groove (Rodel Products Corp.)
Polishing apparatus: LGP-612 (LapmaSter FT Co.)
Pushing pressure: 240 g/$cm^2$
Polishing solution supply rate: 170 mL/min
Wafer diameter: 200 mm
Rotation of polishing pad/wafer: 95/95 rpm

(Evaluation method)

CMP speed: Film thicknesses of metallic films before and after CMP at 49 sites on a surface of the wafer were determined by converting values of electric resistance, to thereby determine an average polishing rate.

In-plane uniformity: Evaluation was performed in accordance with the formula:

[(maximum polishing rate-minimum polishing rate)/(average polishing rate)x2]x100 (%)

The polishing rate and the in-plane uniformity obtained by performing the CMP using the above-described polishing solution are shown in Table 1-1.

<Examples 1-2 to 1-21 and Comparative Examples 1-1 and 1-2>

Polishing solutions of Examples 1-2 to 1-21 and Comparative Examples 1-1 and 1-2 were prepared by using compounds as described in Table 1-1 in a same manner as in Example 1-1 and, then, a polishing test was performed. The results are shown in Table 1-1.

Table 1-1

| | Composition | | | | Evaluation | |
|---|---|---|---|---|---|---|
| | Compound (concentration) | Acid (8g/L) | Oxidizing agent (10g/L) | pH | CMP speed (nm/min) | In-plane uniformity (%) |
| Example 1-1 | I-1 (0.1g/L) | Glycine | Hydrogen peroxide | 7.0 | 630 | 9.8 |
| Example 1-2 | I-4 (0.1g/L) | Glycine | Hydrogen peroxide | 7.0 | 605 | 10.5 |
| Example 1-3 | I-10 (0.1g/L) | Glycine | Hydrogen peroxide | 7.0 | 680 | 9.1 |
| Example 1-4 | I-15 (0.1g/L) | Glycine | Hydrogen peroxide | 7.0 | 700 | 8.5 |
| Example 1-5 | I-21 (0.1g/L) | Glycine | Hydrogen peroxide | 7.0 | 710 | 10.2 |
| Example I-6 | I-22 (0.1g/L) | Glycine | Hydrogen peroxide | 7.0 | 750 | 8.4 |
| Example 1-7 | I-23 (0.1g/L) | Glycine | Hydrogen peroxide | 7.0 | 740 | 10.8 |
| Example 1-8 | I-32 (0.1g/L) | Glycine | Hydrogen peroxide | 7.0 | 610 | 9.8 |
| Example 1-9 | I-41 (0.1g/L) | Glycine | Hydrogen peroxide | 7.0 | 730 | 9.5 |
| Example 1-10 | I-48 (0.1g/L) | Glycine | Hydrogen peroxide | 7.0 | 830 | 8.1 |
| Example 1-11 | I-1 (0.1g/L) | Glycine | Hydrogen peroxide | 4.0 | 650 | 9.3 |
| Example 1-12 | I-1 (0.1g/L) | Glycine | Hydrogen peroxide | 8.5 | 610 | 8.3 |
| Example 1-13 | I-1 (0.1g/L) | Glycine | Hydrogen peroxide | 10 | 590 | 10.5 |

Table continued

| | Composition | | | | Evaluation | |
|---|---|---|---|---|---|---|
| | Compound (concentration) | Acid (8g/L) | Oxidizing agent (10g/L) | pH | CMP speed (nm/min) | In-plane uniformity (%) |
| Example 1-14 | I-1 (0.05g/L) | Glycine | Hydrogen peroxide | 7.0 | 615 | 9.5 |
| Example 1-15 | I-1 (0.5g/L) | Glycine | Hydrogen peroxide | 7.0 | 630 | 9.3 |
| Example 1-16 | I-1 (0.3g/L) | Glycine | Hydrogen peroxide | 7.0 | 580 | 11.5 |
| Example 1-17 | I-1 (0.1g/L) | Malic acid | Hydrogen peroxide | 7.0 | 625 | 8.8 |
| Example 1-18 | I-1 (0.1g/L) | Tartaric acid | Hydrogen peroxide | 7.0 | 630 | 9.1 |
| Example 1-19 | I-15 (0.1g/L) | Malic acid | Hydrogen peroxide | 7.0 | 635 | 7.5 |
| Example 1-20 | 1-15 (0.1g/L) | Tartaric acid | Hydrogen peroxide | 7.0 | 645 | 7.8 |
| Example 1-21 | I-1 (0.1g/L) + polyacrylic acid (3g/L) | Glycine | Ammonium persulfate | 7.0 | 650 | 7.8 |
| Comparative Example 1-1 | Benzotriazole (0.1g/L) | Glycine | Hydrogen peroxide | 7.0 | 400 | 16.5 |
| Comparative Example 1-2 | Benzotriazole (0.1g/L) | Glycine | Hydrogen peroxide | 4.0 | 450 | 18.8 |

As shown in Table 1-1, as to the polishing solution containing the compound represented by the general formula (I), a remarkable increase of the polishing rate and an effect of enhancing the in-plane uniformity was confirmed.

<Examples 1-22 to 1-27 and Comparative Example 1-3>

Each polishing solution shown in Table 1-2 was prepared as described below.

(Preparation of polishing solution)

| | |
|---|---|
| A compound represented by the general formula (I) or benzotriazole as shown in Table 1-2 | 0.1 g/L |
| Hydrogen peroxide (oxidizing agent) | 10 g/L |
| Alanine (acid) | 8.5 g/L |
| Entire volume made up to with purified water | 1000 mL |

Further, when the abrasive grains and the hydrophilic polymer were added, the abrasive grains [colloidal silica (average grain diameter: 30 nm)] and the hydrophilic polymer [polyacrylic acid (molecular weight: 20000)] were added such that respective concentrations thereof came to be those as shown in Table 1-2.

The resultant polishing solutions were subjected to the polishing test as described below and the polishing rate and dishing thereof were evaluated.

(Polishing test)

Substrate: silicon substrate on which a film of copper/silver alloy having a thickness of 1 μm is formed
Polishing pad: IC1400K-Groove (Rodel Products Corp.)
Polishing apparatus: LGP-612 (LapmaSter FT Co.)
Pushing pressure: 240 g/cm$^2$
Polishing solution supply rate: 170 mL/min
Wafer diameter: 200 mm
Rotation of polishing pad/wafer: 95/95 rpm

(Evaluation method)

Average polishing rate (RR): Film thicknesses of metallic films before and after CMP at 49 sites on a surface of the wafer were determined by converting values of electric resistance, to thereby determine an average polishing rate.
Dishing: a step on a wiring portion (line: 100 μm; space: 100 μm) after polishing was measured by using a fine shape measuring apparatus.

Table 1-2

| | Compound (0.1g/L) | Concentration of abrasive grains (% by mass) | pH | Hydrophilic polymer (% by mass) | Polishing rate (nm/min) | Dishing (nm) |
|---|---|---|---|---|---|---|
| Example 1-22 | I-1 | 0 | 7.1 | None | 530 | 50 |
| Example 1-23 | I-1 | 0.002 | 7.1 | None | 580 | 70 |
| Example 1-24 | I-1 | 0.002 | 9.5 | None | 480 | 45 |
| Example 1-25 | I-1 | 0 | 7.1 | 0.3 | 500 | 40 |
| Example 1-26 | 1-1 | 0.002 | 3.2 | None | 520 | 170 |
| Example 1-27 | 1-1 | 0.02 | 7.1 | None | 700 | 80 |
| Comparative Example 1-3 | Benzotriazole | 0.002 | 7.1 | None | 420 | 150 |

It is found from Table 1-2 that the polishing solution containing the compound represented by the general formula (I) and less than 0.01% by mass of abrasive grains is particularly excellent not only in the polishing rate but also in the dishing.
Hereinafter, the second invention is described in detail with reference to Examples and is not limited thereto.

[Test I: Dishing suppressing property test]

(Polishing test)

Substrate: silicon substrate on which a copper film having a thickness of 1 μm is formed
Polishing pad: IC1400 (Rodel Products Corp.)
Polishing apparatus: BC-15 (MAT)
Pushing pressure: 7000, 14000 Pa
Polishing solution supply rate: 50 mL/min
Wafer diameter: Ø60 mm
Relative movement speed of polishing pad/wafer: 1.0 to 2.0 m/s (average relative movement speed of wafer in-plane)

(Preparation of polishing solution for CMP)

Respective polishing solution samples in Examples 2-1 to 2-15 and Comparative Examples 2-1 to 2-3 were prepared by varying types and amounts of abrasive grains, acids, oxidizing agents and compounds as represented by the general formulae (I) and (II) as shown in Table 2-1.

(Evaluation method)

<CMP speed>

Film thicknesses of metallic films before and after CMP at 17 sites on a surface of the wafer were determined by converting values of electric resistance, to thereby determine an average polishing rate.
Measuring apparatus: direct current 4-probe type sheet resistance measuring apparatus VR-120 (available from Hitachi Kokusai Electric Inc.)

<Dishing>

A commercial pattern wafer was polished and, then, a dishing amount in a 100 μm-wiring portion on a wafer was measured.
Article to be polished: 854 mask-pattern wafer (available from SEMATEC GmbH)
Measuring apparatus: direct current 4-probe type sheet resistance measuring apparatus VR-120 (available from Hitachi Kokusai Electric Inc.)

<Etching rate>

A wafer was dipped in a prepared sample and film thicknesses thereof before and after CMP were determined by converting intensities of electric resistance, to thereby determine an average etching rate.
Measuring apparatus: direct current 4-probe type sheet resistance measuring apparatus VR-120 (available from Hitachi Kokusai Electric Inc.)

(Test)

CMP was performed by using the above-described polishing solution for metal and under the CMP conditions. The resultant dishing extents are shown in Table 2-1.

Table 2-1

| | Example 2-1 | Example 2-2 | Example 2-3 | Example 2-4 | Example 2-5 | Example 2-6 | Example 2-7 | Example 2-8 |
|---|---|---|---|---|---|---|---|---|
| Abrasive grains | Colloidal silica | | | | | | | |
| (wt%) | 5 | | | | | | | |
| Acid | Glycine | | | | | | | |
| (wt%) | 1 | | | | | | | |
| Oxidizing agent | Hydrogen peroxide | | | | | | | |
| (wt%) | 1 | | | | | | | |
| Compound | I-1 | | | | | I-4 | I-16 | I-23 |
| (wt%) | 0.003 | | | 0.006 | 0.028 | 0.004 | 0.008 | 0.008 |
| pH | 7 | | | | | | | |
| Relative movement speed(m/s) | 1 | | 2 | 1 | | | 2 | |
| Processing pressure (Pa) | 7000 | 14000 | | | | | | |
| Etching rate | 120 | 120 | 120 | 110 | 50 | 90 | 100 | 110 |
| Polishing rate (nm/min) | 670 | 900 | 980 | 750 | 550 | 780 | 820 | 880 |
| Dishing (nm) | 150 | 170 | 120 | 160 | 170 | 170 | 150 | 170 |

Continuation of Table 2-1

| | Example 2-9 | Example 2-10 | Example 2-11 | Example 2-12 | Example 2-13 | Example 2-14 | Example 2-15 | Comparative Example 2-1 | Comparative Example 2-2 | Comparative Example 2-3 |
|---|---|---|---|---|---|---|---|---|---|---|
| Abrasive grains | Colloidal silica | | | | | | | | | |
| (wt%) | 5 | | | | | | | | | |
| Acid | Glycine | | | Citric acid | Malic acid | EDTA | Glycine | Glycine | | |
| (wt%) | 1 | | | | | | | | | |
| Oxidizing agent | Hydrogen peroxide | | | | | | APS | Hydrogen peroxide | | |
| (wt%) | 1 | | | | | | | | | |
| Compound | II-5 | II-9 | II-10 | I-1 | I-1 | I-1 | I-1 | BTA | | - |
| (wt%) | 0.007 | 0.006 | 0.006 | 0.003 | 0.003 | 0.003 | 0.003 | 0.005 | | - |
| pH | 7 | | | | | | | | | |
| Relative movement speed(m/s) | 1 | | | | | | | | 2 | 1 |
| Processing pressure (Pa) | 7000 | | | 14000 | | | | 7000 | 14000 | 7000 |
| Etching rate | 110 | 110 | 120 | 50 | 20 | 30 | 220 | 20 | | 140 |
| Polishing rate (nm/min) | 700 | 730 | 760 | 320 | 250 | 400 | 1580 | 500 | 680 | 800 |
| Dishing (nm) | 170 | 160 | 180 | 150 | 120 | 100 | 250 | 180 | 200 | 200 |

*APS: ammonium persulfate
*EDTA: ethylene diamine tetraacetic acid

As shown in Table 2-1, it is found that, in Examples 2-1 to 2-15 in each of which the compound represented by the general formula (I) or (II) is contained in the polishing solution, the dishing has efficiently been suppressed without sacrificing the polishing rate to a great extent, compared with Comparative Examples 2-1 to 2-3.

[Test II: Etching suppressing behavior test]

Tests were performed under same conditions as in Example 2-1 and Comparative Example 2-1 except that amounts of the compound I-1 and BTA to be added were changed, to thereby measure dependability of the etching rate on the amounts of the compound I-1 and BTA to be added.

The results are shown in FIG. 2. As is found from FIG. 2, although both the compound (BTA) of Comparative Example and the compound (I-1) of Example suppressed the etching rate, the compound of Example mildly suppressed the etching rate compared with the compound of Comparative Example. Therefore, polishing can effectively be performed within a concentration range in which the dishing is suppressed with less sacrificing the etching rate (for example, in FIG. 2, when the compound concentration is 0.002% by mass, the etching rate in Example remained to be less suppressed as being 120 nm/min whereas that in Comparative Example was largely decreased to 27 nm/min, namely, etching has been suppressed).

By using the polishing solution of metal according to the first invention as a polishing solution to be used in chemical mechanical polishing in the production of a semiconductor device, a marked enhancement of a chemical mechanical polishing rate is attained, a wafer in-plane uniformity is improved and production of an LSI less generating dishing can be realized. Further, generation of defects such as corrosion, scratches, thinning and erosion to be derived from a partial unevenness of polishing can be maintained at a low level.

According to the second invention, it becomes possible to secure a necessary chemical mechanical polishing rate while maintaining generation of defects such as corrosion, scratches, thinning, dishing and erosion to be derived from a partial unevenness of polishing at a low level.

Further, the polishing solution for metal markedly exhibits the above-described effects particularly when a constitutional material of a face to be polished on the semiconductor substrate to be polished uses a copper alloy as a raw material containing a slight amount of silver and thickness of wiring is 0.15 $\mu$m or less and, particularly, less than 0.10 $\mu$m.

The entire disclosure of each and every foreign patent application from which the benefit of foreign priority has been claimed in the present application is incorporated herein by reference, as if fully set forth.

## Claims

1. A polishing solution for metal comprising:

   a compound represented by formula (I); and
   an oxidizing agent:

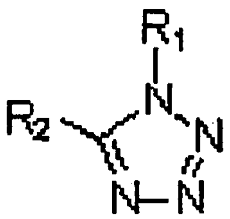

(I)

   wherein $R_1$ and $R_2$ each independently represents a hydrogen atom or a substituent, $R_1$ and $R_2$ may form a ring by combining with each other and, when $R_1$ and $R_2$ simultaneously represent a hydrogen atom, the compound represented by formula (I) may be a tautomer.

2. The polishing solution for metal according to Claim 1, which either not comprises abrasive grains or comprises the abrasive grains in a concentration of less than 0.01% by mass.

3. The polishing solution for metal according to Claim 1, which comprises the abrasive grains in a concentration of 0.01% by mass or more.

4. The polishing solution for metal according to Claim 1, further comprising at least one of an organic acid and an amino acid.

**5.** A chemical mechanical polishing method comprising:

allowing the polishing solution for metal according to Claim 1 to be in contact with a surface to be polished; and performing polishing by moving the surface to be polished and a polishing surface relatively to each other.

**6.** A chemical mechanical polishing method for a semiconductor substrate, comprising:

supplying a polishing solution for metal comprising: at least one compound selected from compounds represented by formulae (I) and (II); and an oxidizing agent;
allowing a polishing face and a face to be polished to be moved relatively to each other while the polishing face and the face to be polished are in contact with each other via the polishing solution for metal; and
performing polishing with a contact pressure between the polishing face and the face to be polished in the range of from 1000 to 25000 Pa:

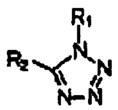 (I) 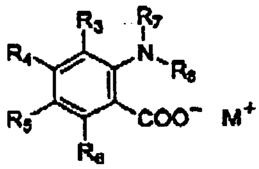 (II)

wherein $R_1$ and $R_2$ each independently represents a hydrogen atom or a substituent, $R_1$ and $R_2$ may form a ring by combining with each other and, when $R_1$ and $R_2$ simultaneously represent a hydrogen atom, the compound represented by formula (I) may be a tautomer; and
$R_3$ to $R_8$ each independently represents a hydrogen atom or a substituent, any two adjacent to each other of $R_3$ to $R_8$ may form a ring by combining with each other and $M^+$ represents a cation.

**7.** The chemical mechanical polishing method for the semiconductor substrate according to Claim 6,
wherein a speed of an average relative movement between the polishing face and the face to be polished is in the range of 0.5 to 5.0 m/s.

**8.** The chemical mechanical polishing method for the semiconductor substrate according to Claim 6,
wherein the face to be polished is a face comprising at least one of copper, a copper alloy, a tantalum-containing compound and an insulating material having a low dielectric constant.

FIG. 1

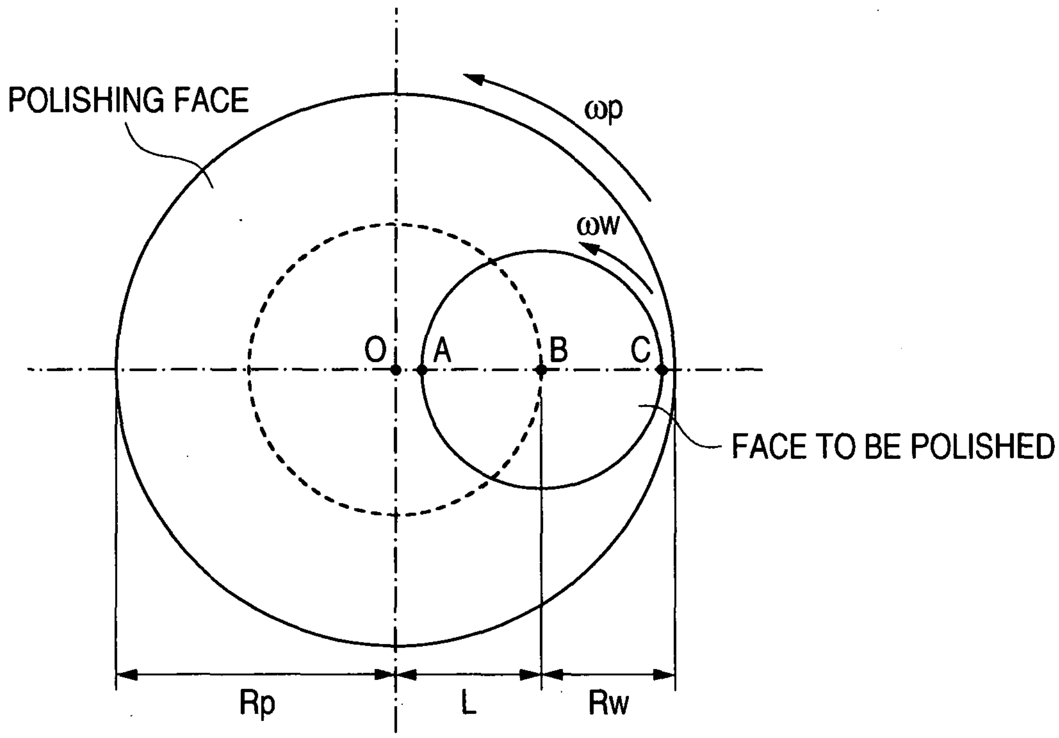

FIG. 2

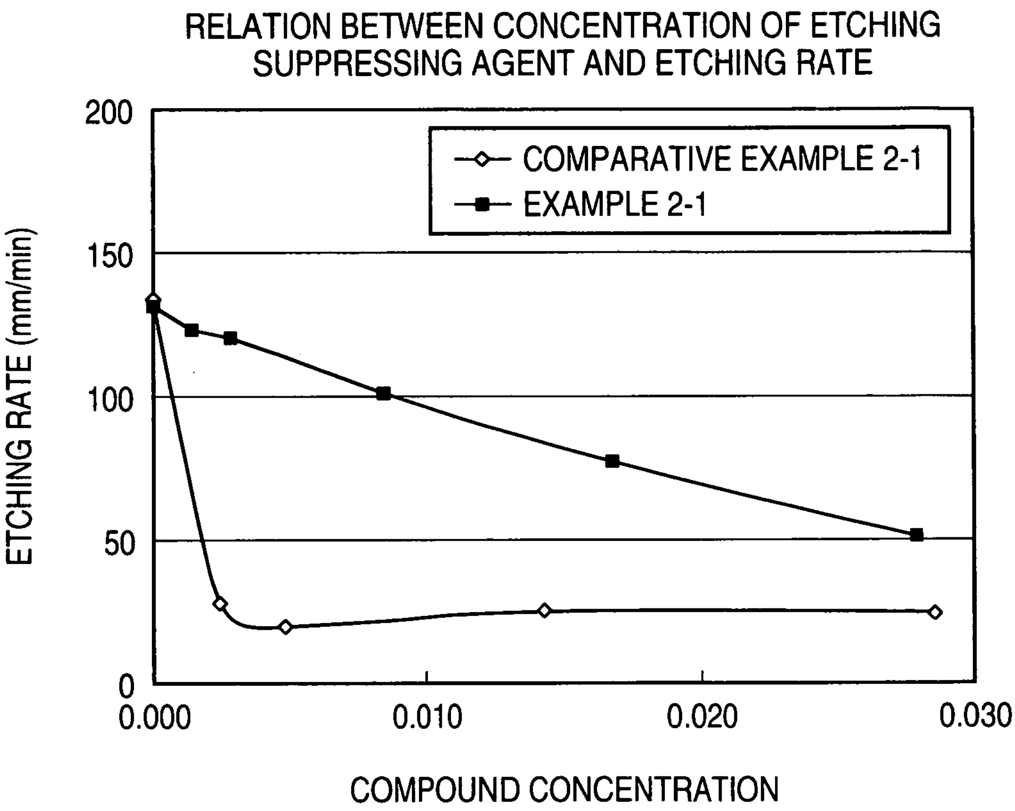
RELATION BETWEEN CONCENTRATION OF ETCHING SUPPRESSING AGENT AND ETCHING RATE
200
150
100
50
0
0.000
0.010
0.020
0.030
ETCHING RATE (mm/min)
COMPOUND CONCENTRATION
COMPARATIVE EXAMPLE 2-1
EXAMPLE 2-1

European Patent Office

# EUROPEAN SEARCH REPORT

Application Number
EP 05 01 4388

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X<br><br><br>A<br>D,X | US 3 948 703 A (KUSHIBE ET AL)<br>6 April 1976 (1976-04-06)<br>* see claims 1 and 4-9; examples 1 and 4 *<br><br>& JP 49 122432 A<br>22 November 1974 (1974-11-22)<br>(cited on page 5 of the description)<br>----- | 1-4<br><br><br>5-8<br>1-4 | C09G1/02<br>C09G1/04<br>H01L21/321 |
| X | US 2004/108302 A1 (LIU JUN ET AL)<br>10 June 2004 (2004-06-10)<br>* see claims 1-2 and 59-60; paragraph 43; examples 1-4 *<br>----- | 1-8 | |
| X | WO 02/059393 A (HONEYWELL INTERNATIONAL INC) 1 August 2002 (2002-08-01)<br>* see page 1, "technical field"; page 11, lines 1-15; page 15, table 2, composition e); claim 1 *<br>----- | 1-8 | |
| X | EP 1 081 200 A (JSR CORPORATION)<br>7 March 2001 (2001-03-07)<br>* see claim 1; paragraphs 42, 48, 51 and 65 *<br>----- | 1-8 | TECHNICAL FIELDS SEARCHED (Int.Cl.7)<br>C09G<br>H01L |
| P,X | EP 1 548 075 A (ROHM AND HAAS ELECTRONIC MATERIALS CMP HOLDINGS, INC)<br>29 June 2005 (2005-06-29)<br>* see claims 1-10; paragraphs 12, 16, 23 and 26; example 1 *<br>----- | 1-8 | |
| P,X | WO 2004/101221 A (ADVANCED TECHNOLOGY MATERIALS, INC; DARSILLO, MICHAEL; WRSCHKA, PETER;)<br>25 November 2004 (2004-11-25)<br>* see examples 1-2 and paragraph 68 *<br>----- | 1-8 | |

1

The present search report has been drawn up for all claims

| Place of search | Date of completion of the search | Examiner |
|---|---|---|
| Munich | 13 September 2005 | Okunowski, F |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
..........................................
& : member of the same patent family, corresponding document

EPO FORM 1503 03.82 (P04C01)

## ANNEX TO THE EUROPEAN SEARCH REPORT ON EUROPEAN PATENT APPLICATION NO. EP 05 01 4388

This annex lists the patent family members relating to the patent documents cited in the above-mentioned European search report.
The members are as contained in the European Patent Office EDP file on
The European Patent Office is in no way liable for these particulars which are merely given for the purpose of information.

13-09-2005

| Patent document cited in search report | Publication date | Patent family member(s) | Publication date |
|---|---|---|---|
| US 3948703 A | 06-04-1976 | JP 965880 C | 26-07-1979 |
| | | JP 49122432 A | 22-11-1974 |
| | | JP 53032341 B | 07-09-1978 |
| JP 49122432 A | 22-11-1974 | JP 965880 C | 26-07-1979 |
| | | JP 53032341 B | 07-09-1978 |
| | | US 3948703 A | 06-04-1976 |
| US 2004108302 A1 | 10-06-2004 | AU 2003297590 A1 | 30-06-2004 |
| | | EP 1570015 A2 | 07-09-2005 |
| | | WO 2004053008 A2 | 24-06-2004 |
| WO 02059393 A | 01-08-2002 | CA 2431591 A1 | 01-08-2002 |
| | | DE 01998054 T1 | 13-01-2005 |
| | | EP 1352109 A1 | 15-10-2003 |
| | | ES 2209676 T1 | 01-07-2004 |
| | | JP 2004524440 T | 12-08-2004 |
| | | US 2004046148 A1 | 11-03-2004 |
| EP 1081200 A | 07-03-2001 | DE 60009997 D1 | 27-05-2004 |
| | | DE 60009997 T2 | 28-04-2005 |
| | | JP 2001077062 A | 23-03-2001 |
| | | US 6447695 B1 | 10-09-2002 |
| EP 1548075 A | 29-06-2005 | CN 1630045 A | 22-06-2005 |
| | | JP 2005167219 A | 23-06-2005 |
| | | US 2005097825 A1 | 12-05-2005 |
| WO 2004101221 A | 25-11-2004 | US 2004229461 A1 | 18-11-2004 |

EPO FORM P0459

For more details about this annex : see Official Journal of the European Patent Office, No. 12/82